# EUROPÄISCHE PATENTSCHRIFT

(11) **EP 4 468 251 B1**
(45) Veröffentlichungstag und Bekanntmachung des Hinweises auf die Patenterteilung: **01.07.2026**
(21) Anmeldenummer: 24176552.8
(22) Anmeldetag: 17.05.2024
(51) Int. Cl.: G06V 10/44, G06V 20/69

(54) **VERFAHREN UND VORRICHTUNG ZUM ANALYSIEREN EINES BILDES EINER MIKROSTRUKTURIERTEN PROBE FÜR DIE MIKROLITHOGRAPHIE**
METHOD AND APPARATUS FOR ANALYZING AN IMAGE OF A MICROSTRUCTURED SAMPLE FOR MICROLITHOGRAPHY
PROCÉDÉ ET DISPOSITIF D'ANALYSE D'UNE IMAGE D'UN ÉCHANTILLON MICROSTRUCTURÉ POUR LA MICROLITHOGRAPHIE

(30) Priorität: 22.05.2023 DE 102023113273
(43) Veröffentlichungstag der Anmeldung: 27.11.2024
(73) Patentinhaber: Carl Zeiss SMT GmbH, 73447 Oberkochen (DE)
(72) Erfinder: OSTER, Jens, 64380 Rossdorf (DE); SCHOENBERGER, Ralf, 64380 Rossdorf (DE); LAENGLE, Mario, 07745 Jena (DE)
(74) Vertreter: HKW Intellectual Property PartG mbB

(56) Entgegenhaltungen:
- DE-A1- 102005 054 401
- US-A1- 2022 383 485

## Beschreibung

Die vorliegende Erfindung betrifft ein Verfahren und eine Vorrichtung zum Analysieren eines Bildes einer mikrostrukturierten Probe für die Mikrolithographie.

Es wird Bezug genommen auf den Inhalt der Prioritätsanmeldung DE 10 2023 113 273.3.

Die Mikrolithographie wird zur Herstellung mikrostrukturierter Bauelemente, wie beispielsweise integrierter Schaltkreise, angewendet. Der Mikrolithographieprozess wird mit einer Lithographieanlage durchgeführt, welche ein Beleuchtungssystem und ein Projektionssystem aufweist. Das Bild einer mittels des Beleuchtungssystems beleuchteten Maske (Retikel) wird hierbei mittels des Projektionssystems auf ein mit einer lichtempfindlichen Schicht (Photoresist) beschichtetes und in der Bildebene des Projektionssystems angeordnetes Substrat, beispielsweise einen Siliziumwafer, projiziert, um die Maskenstruktur auf die lichtempfindliche Beschichtung des Substrats zu übertragen.

Getrieben durch das Streben nach immer kleineren Strukturen bei der Herstellung integrierter Schaltungen werden derzeit EUV-Lithographieanlagen entwickelt, welche Licht mit einer Wellenlänge im Bereich von 0,1 nm bis 30 nm, insbesondere 13,5 nm, verwenden.

Im Zuge der immer kleiner werdenden Strukturgrößen sowohl von im Lithographieprozess verwendeten Masken als auch von mikrolithographisch strukturierten Wafern stellen die Analyse und die Bearbeitung bzw. Reparatur dieser Komponenten in der Praxis eine zunehmend anspruchsvolle Herausforderung dar.

Zur Analyse von mikrostrukturierten Proben, wie beispielsweise mikrostrukturierten Lithographiemasken und Wafern, werden u.a. mikroskopisch erfasste Bilder ausgewertet, um vorhandene Unterschiede zwischen dem jeweiligen Messbild und einem die Sollstruktur der Probe aufweisenden Designbild festzustellen. Die mikroskopisch erfassten Bilder sind insbesondere anhand von Elektronenstrahlen oder Ionenstrahlen erfasste Bilder (z. B. Rasterelektronenmikroskop-Bilder, kurz: REM-Bilder bzw. REM-Bilder). Anhand solcher Bilder ermittelte Unterschiede zwischen dem jeweiligen Messbild und dem die Sollstruktur der Probe aufweisenden Designbild werden als Grundlage für eine Bearbeitung und/oder Reparatur der Probe verwendet. Die zu analysierenden Bilder sind hierbei i.d.R. aus einer Vielzahl von Pixeln zusammengesetzt, wobei jedem Pixel ein Intensitätswert als "Grauwert" zugeordnet ist.

Die Auswertung der mikroskopisch erfassten Bilder der mikrostrukturierten Probe umfasst beispielsweise eine Konturdetektion bzw. -extraktion (Kantendetektion bzw. -extraktion) von Strukturen der mikrostrukturierten Probe. Ein herkömmlicher Ansatz zur Ermittlung von Kanten von Strukturen der Probe basiert z.B. auf einer Gradientenbildung (d. h. der ersten Ableitung) der zweidimensionalen Intensitätsverteilung (d. h. des Grauwertverlaufs) des Bildes, wie z. B. in DE 10 2021 113 764 A1 beschrieben. Aufgrund eines geringen Signal-zu-Rauschverhältnisses der verwendeten Bilder der mikrostrukturierten Probe kann das Erkennen von Kanten erschwert sein. Des Weiteren können Artefakte auf der Maske (z.B. eine Körnung der Oberfläche) und der Bildgebung (Aufhellungen, wie zum Beispiel eine Randaufhellung oder eine Aufhellung durch elektrische Ladung) das Erkennen der Kanten erschweren.

Ferner offenbart die DE 10 2005 054 401 A1 ein Verfahren zum Treffen einer Entscheidung über einen Messwert. Das Verfahren umfasst die Schritte des Erfassens der Signalintensitätsverteilung eines Musters auf dem zu messenden Objekt, die Ermittlung der Rand- bzw. Kantenpositionen des Musters aus der erfassten Signalintensitätsverteilung, der Ermittlung der Verjüngungsbreiten der Rand- bzw. Kantenteile des Musters aus der erfassten Signalintensitätsverteilung und die Bestimmung, dass der auf der Grundlage der ermittelten Rand- bzw. Kantenpositionen berechnete Messwert korrekt ist, wenn die ermittelten Verjüngungsbreiten in einen zuvor festgelegten bestimmten Bereich fallen.

Weiterhin offenbart die US 2022/383 485 A1 ein Verfahren zur Analyse eines Bildes einer mikrostrukturierten Komponente für die Mikrolithographie. Das Verfahren weist folgende Schritte auf: Isolieren einer Mehrzahl von Kantenfragmenten in dem Bild; Klassifizieren jedes der isolierten Kantenfragmente entweder als relevantes Kantenfragment oder als irrelevantes Kantenfragment; und Ermitteln zusammenhängender Segmente in dem Bild auf Basis der relevanten Kantenfragmente.

Vor diesem Hintergrund besteht eine Aufgabe der vorliegenden Erfindung darin, ein verbessertes Verfahren und eine verbesserte Vorrichtung zum Analysieren eines Bildes einer mikrostrukturierten Probe für die Mikrolithographie bereitzustellen.

Demgemäß wird ein Verfahren zum Analysieren eines Bildes einer mikrostrukturierten Probe für die Mikrolithographie vorgeschlagen. Die Probe weist mindestens ein erstes Segment und mindestens ein zweites gegenüber dem ersten Segment erhöhtes Segment mit einer Kante auf. Weiterhin weist das Bild mehrere Pixel und eine zweidimensionale Intensitätsverteilung in Abhängigkeit der Pixel auf. Das Verfahren umfasst die Schritte:
a) Ermitteln mehrerer Kantenkandidaten für ein Abbild der Kante des mindestens einen zweiten Segments basierend auf Gradienten der zweidimensionalen Intensitätsverteilung,
b) Ermitteln einer eindimensionalen Intensitätsverteilung des Bildes in einer Richtung senkrecht zu den mehreren Kantenkandidaten, wobei die eindimensionale Intensitätsverteilung entlang der Richtung einen ersten Bereich mit einem ersten mittleren Intensitätswert, die mehreren Kantenkandidaten und einen zweiten Bereich mit einem zweiten mittleren Intensitätswert, der größer als der erste mittlere Intensitätswert ist, aufweist, und
c) Ermitteln desjenigen der mehreren Kantenkandidaten als das Abbild der Kante des mindestens einen zweiten Segments, welcher unter den mehreren Kantenkandidaten am nächsten bei dem ersten Bereich der eindimensionalen Intensitätsverteilung liegt.

Folglich können in dem Bild der Probe zunächst mehrere Kandidaten für ein Abbild der Kante des mindestens einen zweiten Segments der mikrostrukturierten Probe ermittelt werden. Hierbei kann (zum Beispiel aufgrund eines niedrigen verwendeten Schwellenwerts für einen Betrag des Gradienten) das Ermitteln von Bildartefakten als Kantenkandidaten beispielsweise in Kauf genommen werden. Durch Auswerten der eindimensionalen Intensitätsverteilung des Bildes in der Richtung (orthogonale Richtung) senkrecht zu den mehreren ermittelten Kantenkandidaten kann aus den mehreren ermittelten Kantenkandidaten sodann einer ausgewählt werden und somit als Abbild der Kante des zweiten Segments ermittelt werden. Das Auswählen eines Kantenkandidaten aus den mehreren ermittelten Kantenkandidaten erfolgt insbesondere derart, dass derjenige Kantenkandidat als Abbild der Kante des zweiten Segments ermittelt wird, der am nächsten bei dem ersten Bereich der eindimensionalen Intensitätsverteilung - und somit am nächsten zu dem Bereich der eindimensionalen Intensitätsverteilung mit dem niedrigeren mittleren Intensitätswert (d. h. dem dunkleren Bereich in dem Bild) - liegt. Der dunklere Bereich in dem erfassten Bild entspricht üblicherweise der tiefergelegenen Struktur der Probe (d. h. dem mindestens einen ersten Segment der Probe).

Folglich kann die Lage bzw. Position von Kanten der mikrostrukturierten Probe besser erkannt werden. Insbesondere werden auch Artefakte besser aussortiert.

Insbesondere sind die mit dem vorgeschlagenen Verfahren ermittelten Kantenpositionen detailgenauer und positionsgenauer an die geometrische Form des mindestens einen zweiten Segments angelegt. Weiterhin wird im Vergleich zu herkömmlichen Methoden eine Kantenposition ermittelt, die näher in Richtung der tiefergelegenen Struktur der Probe liegt.

Das mikroskopisch erfasste Bild der Probe ist beispielsweise ein mittels eines Teilchenstrahls, z. B. eines Elektronenstrahls oder eines Ionenstrahls, erfasstes Bild. Das mikroskopisch erfasste Bild der Probe ist beispielsweise ein Rasterelektronenmikroskop-Bild (REM-Bild bzw. SEM-Bild) der Probe.

In dem mikroskopisch erfassten Bild der Probe ist beispielsweise zumindest ein Teil der Probe erfasst. Außerdem ist in dem mikroskopisch erfassten Bild der Probe insbesondere zumindest ein Teil des ersten und zweiten Segments und die Kante des zweiten Segments, welche das zweite Segment von dem ersten Segment abtrennt, erfasst.

Das mit dem Verfahren analysierte Bild weist insbesondere mehrere zweidimensional angeordnete Pixel auf. Jedem Pixel ist ein jeweiliger Intensitätswert zugeordnet ist. Die zweidimensional angeordneten Intensitätswerte bilden insbesondere die zweidimensionale Intensitätsverteilung des Bildes.

Das mindestens eine zweite Segment weist beispielsweise parallel zu einer Haupterstreckungsebene der Probe und/oder senkrecht zu einer Sehlinie einer Bildaufnahmeeinrichtung eine umlaufende, geschlossene Gesamtkante auf. Das bei dem Verfahren ermittelte Abbild der Kante des zweiten Segments kann beispielsweise einem Abschnitt der Gesamtkante entsprechen.

Das mindestens eine erste und zweite Segment sind beispielsweise parallel zur Haupterstreckungsebene der Probe und/oder senkrecht zur Sehlinie der Bildaufnahmeeinrichtung jeweils Zusammenhangsgebiete. Für ein Zusammenhangsgebiet gilt, dass sich je zwei Punkte in einem solchen Gebiet stets durch einen ganz in diesem Gebiet liegenden Streckenzug verbinden lassen.

Die Kante des mindestens einen zweiten Segments der Probe ist insbesondere eine physische Grenze des zweiten Segments, die das zweite Segment von dem ersten Segment abtrennt.

In Schritt a) werden beispielsweise mehrere parallele Kantenkandidaten für ein Abbild der Kante des mindestens einen zweiten Segments basierend auf Gradienten der zweidimensionalen Intensitätsverteilung ermittelt.

In Schritt a) werden insbesondere mehrere Kantenkandidaten für ein und dieselbe Kante (z. B. für ein und denselben Abschnitt einer Gesamtkante) des mindestens einen zweiten Segments basierend auf Gradienten der zweidimensionalen Intensitätsverteilung ermittelt.

Das Ermitteln der mehreren Kantenkandidaten für ein Abbild der Kante des mindestens einen zweiten Segments basierend auf den Gradienten der zweidimensionalen Intensitätsverteilung in Schritt a) erfolgt zum Beispiel basierend auf geeigneten bekannten Methoden, wie beispielsweise "Canny", "Laplacian of Gaussian", "Sobel" etc. Es können auch zwei oder mehr dieser Methoden (z. B. nacheinander) angewendet werden. Zusätzlich oder alternativ kann auch ein- und dieselbe Kantenextraktionsmethode mehrfach mit unterschiedlichen Parametereinstellungen angewendet werden.

Das Ermitteln der mehreren Kantenkandidaten für ein Abbild der Kante des mindestens einen zweiten Segments basierend auf den Gradienten der zweidimensionalen Intensitätsverteilung weist beispielsweise ein Ermitteln eines Gradienten der Intensitätsverteilung an jedem Pixel des Bildes auf. Ein Gradient für ein bestimmtes Pixel wird beispielsweise basierend auf der Auswertung einer vorbestimmten Anzahl von dieses Pixel umgebenden Pixel ermittelt. Die vorbestimmte Anzahl weist z. B. die um das zentrale Pixel angeordneten Pixel in einem 3 x 3 Pixel, 5 x 5 Pixel, 7 x 7 Pixel, 9 x 9 Pixel und/oder 11 x 11 Pixel großen Quadrat auf. Dabei können die einzelnen Pixel mit unterschiedlicher vorbestimmter Gewichtung in die Berechnung des Gradienten eingehen. Das Ermitteln der mehreren Kantenkandidaten des zweiten Segments weist zum Beispiel ein Ermitteln einer Matrix von Gradienten (z. B. ein Gradienten-Bild) aus dem Originalbild (d. h. der zweidimensionalen Intensitätsverteilung) auf. An den Pixeln, an denen sich die Intensität (Helligkeit) des Originalbildes am stärksten ändert und somit das Gradienten-Bild die größten Intensitäten aufweist, liegen die Kanten der in dem Bild erfassten Segmente. Mit anderen Worten entspricht eine Kante einem Bereich großer Gradienten der Intensitätsverteilung.

Das Ermitteln der mehreren Kantenkandidaten für ein Abbild der Kante des zweiten Segments in Schritt a) weist beispielsweise ein Ermitteln von Pixeln des Bildes auf, welche Kandidaten für Kantenpixel sind.

In Schritt c) wird insbesondere derjenige der mehreren Kantenkandidaten als das Abbild der Kante des mindestens einen zweiten Segments ermittelt, welcher unter den mehreren Kantenkandidaten örtlich bzw. in Bezug auf eine Position entlang der orthogonalen Richtung am nächsten bei dem ersten Bereich der eindimensionalen Intensitätsverteilung liegt.

Das Ermitteln der eindimensionalen Intensitätsverteilung des Bildes in der Richtung senkrecht zu den mehreren ermittelten Kantenkandidaten kann beispielsweise auch ein Mitteln in einer Richtung parallel zu den mehreren ermittelten Kantenkandidaten über mehrere Pixel aufweisen, um ein Signal-zu Rauschverhältnis der ermittelten eindimensionalen Intensitätsverteilung zu vergrößern.

Bei dem Ermitteln der eindimensionalen Intensitätsverteilung des Bildes umfasst "senkrecht zu den mehreren ermittelten Kantenkandidaten" beispielsweise senkrecht zu einem, zu mehreren oder zu allen der mehreren ermittelten Kantenkandidaten.

Die eindimensionale Intensitätsverteilung weist in der Umgebung der mehreren ermittelten Kantenkandidaten den ersten und zweiten Bereich auf, welche voneinander verschiedene mittlere Intensitätswerte haben. Mit anderen Worten werden die mehreren ermittelten Kantenkandidaten von einem helleren Bereich (zweiter Bereich) und einem dunkleren Bereich (erster Bereich) flankiert. Durch Berücksichtigen dieser Bereiche kann die relevante Kante unter den mehreren Kantenkandidaten besser ausgewählt werden.

Der erste und zweite Bereich der eindimensionalen Intensitätsverteilung entsprechen insbesondere kantenfreien Bereichen der Probe. Mit anderen Worten entsprechen der erste und zweite Bereich der eindimensionalen Intensitätsverteilung insbesondere Bereichen der Probe, für die in Schritt a) keine Kantenkandidaten ermittelt wurden.

Die mikrostrukturierte Probe weist beispielsweise eine flache Form mit einer Haupterstreckungsebene und einer senkrecht zur Haupterstreckungsebene angeordneten Höhenrichtung auf. Das mikroskopische Bild der Probe ist beispielsweise mit einer Bildaufnahmeeinrichtung aufgenommen, deren Sehlinie parallel zur Höhenrichtung der Probe angeordnet ist.

Das mindestens eine erste Segment der Probe weist in Bezug auf die Höhenrichtung der Probe beispielsweise eine erste Höhe auf. Das mindestens eine zweite Segment der Probe weist in Bezug auf die Höhenrichtung der Probe beispielsweise eine zweite Höhe auf, welche größer als die erste Höhe ist. Die Kante des mindestens einen zweiten Segments weist beispielsweise eine Kantenwand auf.

Die Kantenwand kann senkrecht zur Haupterstreckungsebene der Probe und parallel zur Höhenrichtung angeordnet sein. Die Kantenwand kann jedoch auch geneigt zur Haupterstreckungsebene der Probe angeordnet sein.

Gemäß einer Ausführungsform basiert der erste Bereich der eindimensionalen Intensitätsverteilung des Bildes auf einer Abbildung des mindestens einen ersten Segments der Probe, und basiert der zweite Bereich der eindimensionalen Intensitätsverteilung des Bildes auf einer Abbildung des mindestens einen zweiten Segments der Probe.

Damit wird derjenige Kantenkandidat aus den mehreren ermittelten Kantenkandidaten ausgewählt und somit als das Abbild der Kante des zweiten Segments ermittelt, der in Bezug auf die orthogonale Richtung am nächsten bei dem dunkleren Bereich des Bildes liegt, welcher der tiefergelegenen Struktur (dem ersten Segment) der Probe entspricht.

Gemäß einer weiteren Ausführungsform weist das mindestens eine erste Segment der Probe ein erstes Material auf, und weist das mindestens eine zweite Segment der Probe ein von dem ersten Material verschiedenes zweites Material auf.

Insbesondere weisen beispielsweise eine freiliegende Oberfläche des mindestens einen ersten Segments und eine freiliegende Oberfläche des mindestens einen zweiten Segments voneinander verschiedene Materialien auf.

Gemäß einer weiteren Ausführungsform ist der zweite mittlere Intensitätswert des zweiten Bereichs der eindimensionalen Intensitätsverteilung des Bildes aufgrund des Materialunterschieds des mindestens einen ersten und zweiten Segments der Probe größer als der erste mittlere Intensitätswert des ersten Bereichs der eindimensionalen Intensitätsverteilung des Bildes.

Damit befinden sich in Bezug auf die orthogonale Richtung rechts und links neben den mehreren ermittelten Kantenkandidaten verschiedene Materialien der Probe, welche mit unterschiedlichen Helligkeiten (Intensitätswerten) in dem Bild abgebildet werden. Die durch die unterschiedlichen Materialien in dem Bild verursachten unterschiedlichen Helligkeiten (Intensitätswerte) werden nun dazu herangezogen, unter den mehreren Kantenkandidaten den besten auszuwählen und insbesondere Artefakte auszusortieren.

Der Materialunterschied des mindestens einen ersten und zweiten Segments der Probe ist beispielsweise ein Materialunterschied von (freiliegenden) Oberflächen des mindestens einen ersten und zweiten Segments der Probe.

Gemäß einer weiteren Ausführungsform weist das mindestens eine erste und zweite Segment der Probe das gleiche Material auf.

Insbesondere weisen beispielsweise eine freiliegende Oberfläche des mindestens einen ersten Segments und eine freiliegende Oberfläche des mindestens einen zweiten Segments das gleiche Material auf.

Gemäß einer weiteren Ausführungsform ist der zweite mittlere Intensitätswert des zweiten Bereichs der eindimensionalen Intensitätsverteilung des Bildes aufgrund einer Schattenbildung benachbart zur Kante des mindestens einen zweiten Segments der Probe kleiner als der erste mittlere Intensitätswert des ersten Bereichs der eindimensionalen Intensitätsverteilung des Bildes.

Durch die Schattenbildung des zweiten Segments wird ein an das zweite Segment angrenzender Bereich des ersten Segments mit geringerer Helligkeiten (kleineren Intensitätswerten) in dem Bild abgebildet als das zweite Segment. Die durch die Schattenbildung verursachten unterschiedlichen Helligkeiten (Intensitätswerten) zwischen dem in dem Bild abgebildeten zweiten Segment und dem an das zweite Segment angrenzenden Schattenbereich des ersten Segments werden nun dazu herangezogen, unter den mehreren Kantenkandidaten den treffendsten auszuwählen.

Mit anderen Worten ist der mittlere Intensitätswert des zweiten Bereichs der eindimensionalen Intensitätsverteilung aufgrund der Schattenbildung größer als der mittlere Intensitätswert des Schattenbereichs der eindimensionalen Intensitätsverteilung.

Gemäß einer weiteren Ausführungsform wird bei dem Ermitteln der mehreren Kantenkandidaten basierend auf den Gradienten der zweidimensionalen Intensitätsverteilung ein vorbestimmter Schwellenwert angewendet, sodass für Gradienten der zweidimensionalen Intensitätsverteilung, deren Betrag größer als der vorbestimmte Schwellenwert ist, ein entsprechender Kantenkandidat ermittelt wird, und für Gradienten der zweidimensionalen Intensitätsverteilung, deren Betrag gleich wie oder kleiner als der vorbestimmte Schwellenwert ist, kein Kantenkandidat ermittelt wird.

Durch Einstellen eines niedrigen Schwellenwertes können auch im Bild schwach abgebildete Kanten erfasst werden, allerdings erhöht dies die Anzahl der Artefakte unter den ermittelten Kantenkandidaten. Durch Einstellen eines höheren Schwellenwertes wird die Anzahl der Artefakte unter den ermittelten Kantenkandidaten verringert, allerdings werden dadurch im Bild sehr schwach abgebildete Kanten möglicherweise nicht erfasst.

Gemäß einer weiteren Ausführungsform wird vor Schritt a) eine Bildvorverarbeitung zur Minderung eines Rauschanteils der zweidimensionalen Intensitätsverteilung vorgenommen.

Bei der Bildvorverarbeitung zur Minderung eines Rauschanteils kann eine oder mehrere geeignete Bildglättungsmethode/n angewendet werde. Beispielhafte geeignete Methoden umfassen ein Binning, eine Gauß-Filterung, Tiefpassfilterung etc. Lediglich beispielhaft können hierbei mehrere (z. B. vier oder auch mehr oder weniger) zueinander benachbarte Pixel jeweils durch ein einziges (z. B. mittleres) Pixel ersetzt werden, wobei diesem Pixel dann der mittlere Intensitätswert der mehreren zusammengefassten Pixel zugeordnet wird.

Gemäß einer weiteren Ausführungsform ist die mikrostrukturierte Probe für eine Arbeitswellenlänge von weniger als 250 nm, von weniger als 200 nm, von weniger als 100 nm und/oder von weniger als 15 nm ausgelegt, und/oder
ist die mikrostrukturierte Probe eine Lithographiemaske, insbesondere eine EUV- oder eine DUV-Lithographiemaske, und/oder ein mittels Mikrolithographie strukturierter Wafer

Eine DUV-Lithographiemaske ist beispielsweise eine transmissive Photomaske, bei der ein bei der Lithographie abzubildendes Muster in Form einer absorbierenden (d. h. undurchlässigen oder teilundurchlässigen) Beschichtung (die Beschichtung entspricht dem zweiten Segment) auf einem transparenten Substrat (das transparente Substrat entspricht dem ersten Segment) realisiert ist.

Eine EUV-Lithographiemaske ist beispielsweise eine reflektive Photomaske, bei der das abzubildende Muster in Form einer absorbierenden Beschichtung (die Beschichtung entspricht dem zweiten Segment) auf einem reflektierenden Substrat (das reflektierende Substrat entspricht dem ersten Segment) realisiert ist.

Die Lithographiemaske wird insbesondere in einer Lithographieanlage eingesetzt. Die Lithographieanlage ist zum Beispiel eine EUV- oder eine DUV-Lithographieanlage. Dabei steht EUV für "extremes Ultraviolett" (Engl.: extreme ultraviolet, EUV) und bezeichnet eine Wellenlänge des Arbeitslichts im Bereich von 0,1 nm bis 30 nm, insbesondere 13,5 nm. Weiterhin steht DUV für "tiefes Ultraviolett" (Engl.: deep ultraviolet, DUV) und bezeichnet eine Wellenlänge des Arbeitslichts zwischen 30 nm und 250 nm.

Die EUV- oder DUV-Lithographieanlage umfasst ein Beleuchtungssystem und ein Projektionssystem. Insbesondere wird mit der EUV- oder DUV-Lithographieanlage das Bild einer mittels des Beleuchtungssystems beleuchteten Lithographiemaske (Retikel) mittels des Projektionssystems auf ein mit einer lichtempfindlichen Schicht (Photoresist) beschichtetes und in der Bildebene des Projektionssystems angeordnetes Substrat, beispielsweise einen Siliziumwafer, projiziert, um die Maskenstruktur auf die lichtempfindliche Beschichtung des Substrats zu übertragen.

Gemäß einer weiteren Ausführungsform weist das mindestens eine erste Segment der Probe ein lichtdurchlässiges oder lichtreflektierendes Material auf, und weist das mindestens eine zweite Segment der Probe ein lichtabsorbierendes Material auf.

Die Materialien sind beispielsweise für Licht mit einer Wellenlänge im DUV- und/oder EUV-Bereich des elektromagnetischen Spektrums lichtdurchlässig, lichtreflektierend bzw. lichtabsorbierend.

Beispielsweise weist das mindestens eine erste Segment der Probe ein lichtdurchlässiges Material auf, wenn die Probe eine DUV-Lithographiemaske ist (transmissive Photomaske, Binärmaske). Beispielsweise weist das mindestens eine erste Segment der Probe ein lichtreflektierendes Material auf, wenn die Probe eine EUV-Lithographiemaske ist (reflektive Photomaske).

Das mindestens eine erste Segment der Probe weist beispielsweise ein Substrat auf. Das Substrat umfasst beispielsweise Siliziumdioxid (SiO2), z. B. Quarzglas.

Das mindestens eine erste Segment der Probe kann beispielsweise auch eine oder mehrere Schichten (Beschichtungen) aufweisen. Die eine oder mehreren Schichten umfassen z. B. eine oder mehrere reflektierende Schichten und/oder eine oder mehrere Schutzschichten (z. B. Ru-Capping-Layer).

Das mindestens eine zweite Segment der Probe weist zum Beispiel eine Absorberstruktur auf. Das mindestens eine zweite Segment der Probe weist beispielsweise Chrom, Chromverbindungen, Tantalverbindungen und/oder Verbindungen aus Silizium, Stickstoff, Sauerstoff und/oder Molybdän auf (z. B. Molybdänsiliziumoxid oder Molybdänsiliziumoxinitrid, d. h. Siliziumoxid oder Siliziumnitrid (Si3N4), das mit Molybdän (Mo) (z. B. etwa 5 % Molybdän) dotiert ist und auch als MoSi bezeichnet wird).

Das mindestens eine zweite Segment der Probe kann auch das gleiche Material wie das mindestens eine erste Segment der Probe aufweisen. Dabei kann das entsprechende Material im zweiten Segment mit einer größeren Dicke (d. h. größeren Höhe in Bezug auf eine Höhenrichtung der Probe) als im ersten Segment auf einem Substrat der Probe aufgebracht sein, um die entsprechende lichtabsorbierende bzw. lichtdurchlässige/lichtreflektierende Eigenschaft aufzuweisen. Insbesondere entspricht hier eine größere Dicke (größere Höhe) einer stärker absorbierenden Wirkung.

Gemäß einem weiteren Aspekt wird ein Computerprogrammprodukt vorgeschlagen, welches Befehle umfasst, die bei der Ausführung des Programms durch mindestens einen Computer diesen veranlassen, das vorstehend beschriebene Verfahren auszuführen.

Ein Computerprogrammprodukt, wie z.B. ein Computerprogramm-Mittel, kann beispielsweise als Speichermedium, wie z.B. Speicherkarte, USB-Stick, CD-ROM, DVD, oder auch in Form einer herunterladbaren Datei von einem Server in einem Netzwerk bereitgestellt oder geliefert werden. Dies kann zum Beispiel in einem drahtlosen Kommunikationsnetzwerk durch die Übertragung einer entsprechenden Datei mit dem Computerprogrammprodukt oder dem Computerprogramm-Mittel erfolgen.

Gemäß einem weiteren Aspekt wird eine Vorrichtung zur Analyse eines Bildes einer mikrostrukturierten Probe für die Mikrolithographie vorgeschlagen. Die Probe weist mindestens ein erstes Segment und mindestens ein zweites gegenüber dem ersten Segment erhöhtes Segment mit einer Kante auf. Zudem weist das Bild mehrere Pixel und eine zweidimensionale Intensitätsverteilung in Abhängigkeit der Pixel auf. Außerdem weist die Vorrichtung auf:
eine erste Ermittlungseinrichtung zum Ermitteln mehrerer Kantenkandidaten für ein Abbild der Kante des mindestens einen zweiten Segments basierend auf Gradienten der zweidimensionalen Intensitätsverteilung,
eine zweite Ermittlungseinrichtung, zum Ermitteln einer eindimensionalen Intensitätsverteilung des Bildes in einer Richtung senkrecht zu den mehreren Kantenkandidaten, wobei die eindimensionale Intensitätsverteilung entlang der Richtung einen ersten Bereich mit einem ersten mittleren Intensitätswert, die mehreren Kantenkandidaten und einen zweiten Bereich mit einem zweiten mittleren Intensitätswert, der größer als der erste mittlere Intensitätswert ist, aufweist, und
eine dritte Ermittlungseinrichtung zum Ermitteln desjenigen der mehreren Kantenkandidaten als das Abbild der Kante des mindestens einen zweiten Segments, welcher unter den mehreren Kantenkandidaten am nächsten bei dem ersten Bereich der eindimensionalen Intensitätsverteilung liegt.

Die Vorrichtung ist insbesondere dazu eingerichtet, ein wie vorstehend beschriebenes Verfahren auszuführen.

Das vorstehend beschriebene Verfahren und die vorstehend beschriebene Vorrichtung zur Analyse eines Bildes einer mikrostrukturierten Probe für die Mikrolithographie kann zur Kantenerkennung und -extraktion (Konturerkennung und -extraktion) in vielen verschiedenen Anwendungsfälle angewendet werden.

Beispiele für Anwendungsfälle umfassen das Erkennen von Defekten der Probe (z. B. einer Größe, Position, (geometrischen) Form und eines Umrisses eines Defekts und bei Defekten, die mehrere Segmente i. S. v. mehreren Zusammenhangsgebieten aufweisen, die mehreren Segmente des Defekts) durch Differenzbildung der Strukturen einer defektfreien Referenz mit den Strukturen (erste und zweite Segmente) der mikrostrukturierten Probe des aufgenommenen mikroskopischen Bildes (Engl.: Pattern Copy). Die Referenz kann einem aufgenommenen mikroskopischen Bild entnommen werden; die Referenz kann "leer" sein, so dass die Segmentierung des Defektes mit der Defekterkennung gleichzusetzen ist; die Referenz kann auf einem von einer Designdatei simulierten mikroskopischen Bild basieren; und/oder die Referenz kann auf einer modellbasiert berechneten Konturänderung der Probenstrukturen (z. B. Photomaskenstrukturen) basieren, die physisch hergestellt ist, um ein korrektes Belichtungserhalten der Photomaske beim Waferbelichten herzustellen, dessen Inkorrektheit in einer anderweitig unzugänglichen Ursache bestand.

Beispiele für Anwendungsfälle des vorstehend beschriebenen Verfahrens umfassen außerdem die Erkennung eines sog. opaken Defektes, d. h. von im Vergleich zum Sollzustand der Probe (z. B. Lithographiemaske) überschüssigen Absorbermaterials und die Erkennung eines sog. klaren Defektes, d. h. von im Vergleich zum Sollzustand der Probe (z. B. Lithographiemaske) fehlenden Absorbermaterial. Weiterhin kann mit dem vorgeschlagenen Verfahren auch ein Partikel (z. B. Fremdkörper) als Defekt erkannt werden. Außerdem können Reparaturformen und/oder Bearbeitungsformen (d. h. geometrische Formen, z. B. zweidimensionale geometrische Formen, die einen Bereich kennzeichnen, in dem die Probe repariert und/oder bearbeitet werden muss) ermittelt werden. Die Reparaturformen und/oder Bearbeitungsformen umfassen z. B. Polier-Bearbeitungsformen, die einen Bereich kennzeichnen, in dem die Probe poliert werden muss. Die Polier-Bearbeitungsformen werden zum Beispiel zum feinen Bearbeiten der Kanten oder von Residuen verwendet. Hierzu zählt auch das sogenannte Line Trimming zur leichten Korrektur der Kantenlagen einer Struktur auf der Maske. Mithilfe des Verfahrens können diese Polier-Bearbeitungsformen erkannt und/oder erzeugt werden. Die Reparaturformen und/oder Bearbeitungsformen umfassen z. B. Reparaturformen/Bearbeitungsformen, die einen Bereich kennzeichnen, in dem ein Deponat um eine Reparaturstelle herum in einem Halo auf der Probe abgelegt wurde und wieder entfernt werden muss. Die Reparaturformen und/oder Bearbeitungsformen umfassen z. B. wegzuätzende Bereiche in opaken Gutstrukturen, womit unzugängliche Fehler in klaren Gebieten kompensiert werden können.

In Anwendungsfällen des vorstehend beschriebenen Verfahrens kann die Erkennung von Defekten als eigenständige Produktlösung oder als Prozessschritt eines manuellen oder automatisierten Workflows verwendet werden. Weiterhin kann ein Defekt nach Art, Größe und weiteren Kennwerten klassifiziert werden. Dies kann als eigenständige Produktlösung oder als Prozessschritt eines manuellen oder automatisierten Workflows verwendet werden (Defektklassifizierung). In Anwendungsfällen des vorstehend beschriebenen Verfahrens kann ein Defekt automatisch an einer definierten Stelle im Bild (z. B. in der Bildmitte) positioniert werden. Dies kann als eigenständige Produktlösung oder als Prozessschritt eines manuellen oder automatisierten Workflows verwendet werden (Defektzentrierung, Defektpositonierung).

Weitere Beispiele für Anwendungsfälle des vorstehend beschriebenen Verfahrens umfassen die Erkennung und ggf. Vermessung von Strukturen, z. B. die Vermessung der Kantenabstände der Segmente, eines aufgenommenen mikroskopischen Bildes. Dies kann als eigenständige Produktlösung oder als Prozessschritt eines manuellen oder automatisierten Workflows verwendet werden. Zudem können die Kantenabstände der Segmente eines aufgenommenen mikroskopischen Bildes (REM-Bild) mit den Segmenten eines Referenzbildes verglichen werden. Dies kann als eigenständige Produktlösung oder als Prozessschritt eines manuellen oder automatisierten Workflows verwendet werden. In beiden Fällen gilt, dass das REM-Bild erstens von einer beliebigen Stelle auf einer Photolithographiemaske aufgenommen worden sein kann, und z. B. einen bereits behandelten/reparierten oder einen (z. B. noch gänzlich) unbehandelten Defekt aufweisen kann, und dass das Referenzbild zweitens ein aufgenommenes REM-Bild oder ein aus einer Designdatei simuliertes REM-Bild sein kann.

Weitere Anwendungsfälle des vorstehend beschriebenen Verfahrens umfassen die Nutzung der Erkennung der Segmente eines REM-Bildes einer Photolithographiemaske zur Modellierung des dreidimensionalen Aufbaus der unterschiedlichen Strukturen bzw. Ebenen der Photolithographiemaske. Dies kann als eigenständige Produktlösung oder als Prozessschritt eines manuellen oder automatisierten Workflows verwendet werden.

Weitere Anwendungsfälle des vorstehend beschriebenen Verfahrens umfassen die Nutzung der Erkennung der Segmente eines REM-Bildes einer Photolithographiemaske zur Simulation des im Lithographieprozess erzeugten optischen Luftbildes der Photolithographiemaske. Dies kann als eigenständige Produktlösung oder als Prozessschritt eines manuellen oder automatisierten Workflows verwendet werden. Außerdem können Segmente an unterschiedlichen Positionen der Photolithographiemaske in den aufgenommenen REM-Bildern erkannt werden zur Bestimmung des Abstandes und der absoluten Position der Strukturen. Dies kann als eigenständige Produktlösung oder als Prozessschritt eines manuellen oder automatisierten Workflows verwendet werden. Darüber hinaus können auch Segmente in einem REM-Bild einer Photolithographiemaske erkannt werden zum Vergleich mit einem aus anderer Quelle erzeugten Bild derselben Struktur mit dem Ziel des Positionsabgleiches (Bild-Registrierung, Positionsabgleich, Positionskalibrierung).

Weitere Beispiele für Anwendungsfälle des vorstehend beschriebenen Verfahrens umfassen die Erkennung von Segmenten in einem REM-Bild zur geeigneten Platzierung von Drift-Korrekturmarkern unter den vorgegebenen Randbedingungen (z.B. Deposition ausschließlich auf Absorbermaterial, Mindestabstand vom Defekt, Mindestabstand zur nächstgelegenen Strukturkante, maximal symmetrische Verteilung) und zur automatischen Driftkorrektur. Auch können Segmente in einem REM-Bild erkannt werden, welche zur Strahloptimierung (z. B. Fokussierung, De-Stigmatisierung, Blenden-Alignment) geeignet sind. Zudem kann ein Automatismus vorgesehen sein, der erkennt, ob eine definierte Struktur im Bildfeld vorhanden ist, und der beispielsweise automatisiert eine Warnung ausgibt, wenn diese Struktur aus dem Sichtfeld verschwunden ist. Ein weiterer Anwendungsfall ist das Erkennen von Strukturen in einem REM-Bild als Suchhilfe zum Finden von außerhalb des Sichtfeldes gelegenen Ziel-Strukturen (automatisches globales Ausrichten). Mit dem vorstehend beschriebenen Verfahren können auch Segmente einer an einer Elektronensäule angebrachten Hardware erkannt werden, um den aus der Elektronensäule austretenden Elektronenstrahl an dieser Hardware auszurichten.

Die vorstehend beschriebenen Beispiele für Anwendungsfälle können in Vorrichtungen zur Maskenreparatur und/oder Maskenbearbeitung als auch als eigenständige Produkte eingesetzt werden.

"Ein" ist vorliegend nicht zwingend als beschränkend auf genau ein Element zu verstehen. Vielmehr können auch mehrere Elemente, wie beispielsweise zwei, drei oder mehr, vorgesehen sein. Auch jedes andere hier verwendete Zählwort ist nicht dahingehend zu verstehen, dass eine Beschränkung auf genau die genannte Anzahl von Elementen gegeben ist. Vielmehr sind zahlenmäßige Abweichungen nach oben und nach unten möglich, soweit nichts Gegenteiliges angegeben ist.

Die für das Verfahren beschriebenen Ausführungsformen und Merkmale gelten für die vorgeschlagene Vorrichtung entsprechend und umgekehrt.

Weitere mögliche Implementierungen der Erfindung umfassen auch nicht explizit genannte Kombinationen von zuvor oder im Folgenden bezüglich der Ausführungsbeispiele beschriebenen Merkmalen oder Ausführungsformen. Dabei wird der Fachmann auch Einzelaspekte als Verbesserungen oder Ergänzungen zu der jeweiligen Grundform der Erfindung hinzufügen.

Weitere vorteilhafte Ausgestaltungen und Aspekte der Erfindung sind Gegenstand der Unteransprüche sowie der im Folgenden beschriebenen Ausführungsbeispiele der Erfindung. Im Weiteren wird die Erfindung anhand von bevorzugten Ausführungsformen unter Bezugnahme auf die beigelegten Figuren näher erläutert.
Fig. 1 zeigt ein Flussablaufdiagramm eines Verfahrens zum Analysieren eines Bildes einer mikrostrukturierten Probe für die Mikrolithographie gemäß einer Ausführungsform;
Fig. 2 zeigt eine Draufsicht eines Ausschnitts einer mikrostrukturierten Probe gemäß einer Ausführungsform;
Fig. 3 zeigt einen Querschnitt aus Fig. 2 entlang Linie III-III;
Fig. 4 zeigt eine Vorrichtung zum Aufnehmen eines mikroskopischen Bildes einer mikrostrukturierten Probe gemäß einer Ausführungsform;
Fig. 5 zeigt ein mit der Vorrichtung aus Fig. 4 aufgenommenes Bild einer mikrostrukturierten Probe gemäß einer Ausführungsform;
Fig. 6 zeigt eine eindimensionale Intensitätsverteilung des in Fig. 5 gezeigten Bildes;
Fig. 7 zeigt einen vergrößerten Teilausschnitt der Intensitätsverteilung aus Fig. 6;
Fig. 8 zeigt ein Diagramm eines Gradienten der Intensitätsverteilung aus Fig. 7 gemäß einer Ausführungsform;
Fig. 9 zeigt ein weiteres mikroskopisches Bild einer mikrostrukturierten Probe vor und nach einer Kantenerkennung von Segmenten gemäß einer Ausführungsform;
Fig. 10 zeigt ein weiteres Bild einer mikrostrukturierten Probe gemäß einer Ausführungsform, wobei das Verwenden einer Abschattung zur Kantenerkennung gemäß einer Ausführungsform veranschaulicht ist; und
Fig. 11 zeigt eine eindimensionale Intensitätsverteilung des in Fig. 10 gezeigten Bildes.

In den Figuren sind gleiche oder funktionsgleiche Elemente mit denselben Bezugszeichen versehen worden, soweit nichts Gegenteiliges angegeben ist. Ferner sollte beachtet werden, dass die Darstellungen in den Figuren nicht notwendigerweise maßstabsgerecht sind.

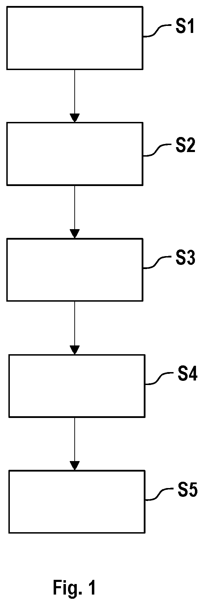

Im Folgenden wird anhand der Figuren 1 bis 10 ein Verfahren zum Analysieren einer mikrostrukturierten Probe 100 für die Mikrolithographie, insbesondere eines Bildes 300 einer mikrostrukturierten Probe 100 für die Mikrolithographie, beschrieben.

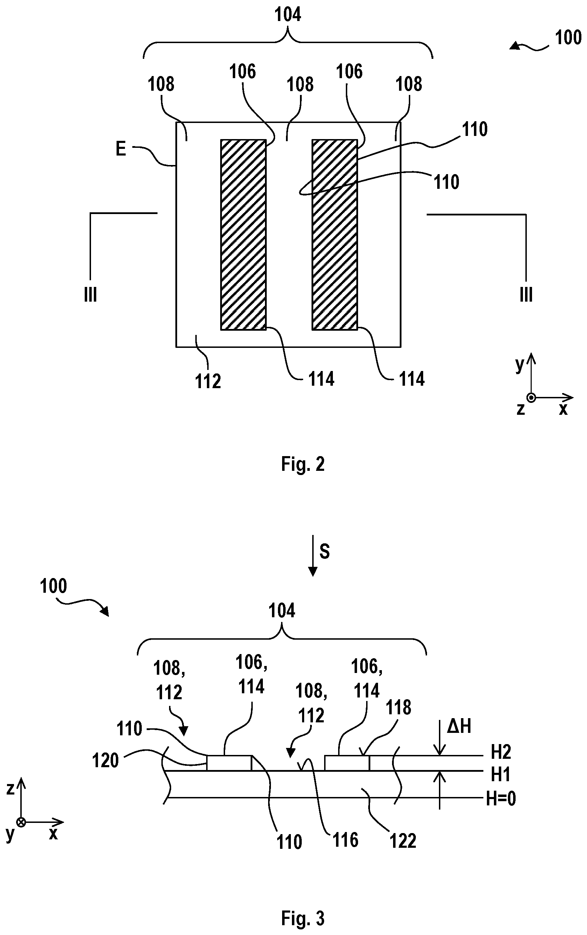

In Fig. 2 ist ein Ausschnitt einer beispielhaften mikrostrukturierten Probe 100 gezeigt. Fig. 3 zeigt den in Fig. 2 gezeigten Ausschnitt der Probe 100 in einer Querschnittsansicht entlang Linie III-III in Fig. 2. Die Probe 100 weist eine Mikrostruktur 104 auf. Die Mikrostruktur 104 umfasst zum Beispiel ein oder mehrere erhöhte Elemente 106 (z. B. Absorberstrukturen 106) und angrenzende niedrigere Gebiete 108 auf. Beispielsweise weist die Mikrostruktur 104 ein oder mehrere erhöhte Elemente 106 mit dazwischenliegenden niedrigeren Gebieten 108 (z. B. Gräben 108) auf. Die erhöhten Elemente 106 weisen Kanten 110 auf, von denen in Fig. 2 zwei mit einem Bezugszeichen versehen sind. Die niedrigeren Gebieten 108 weisen insbesondere ein oder mehrere erste Segmente 112 auf. Weiterhin weisen die erhöhten Elemente 106 ein oder mehrere zweite Segmente 114 auf, welche gegenüber dem einen oder den mehreren ersten Segmenten 112 erhöht sind. In Fig. 2 sind lediglich beispielhaft zwei zweite Segmente 114 zu sehen.

Die mikrostrukturierte Probe 100 weist außerdem beispielsweise eine flache Form mit einer Haupterstreckungsebene E (xy-Ebene in Fig. 2 und 3) auf. Eine Richtung senkrecht zur Haupterstreckungsebene E wird als eine Höhenrichtung z der Probe 100 bezeichnet.

Jedes der zweiten Segmente 114 in Fig. 2 ist zum Beispiel ein Zusammenhangsgebiet in einer Ebene parallel zur Haupterstreckungsebene E der Probe 100.

Wie im Querschnitt von Fig. 3 gezeigt, weist das mindestens eine erste Segment 112 der Probe 100 in Bezug auf die Höhenrichtung z der Probe 100 eine erste Höhe H1 auf. Außerdem weist das mindestens eine zweite Segment 114 der Probe 100 in Bezug auf die Höhenrichtung z eine zweite Höhe H2 auf, welche größer als die erste Höhe H1 ist. Insbesondere erhebt sich das mindestens eine zweite Segment 114 um eine Höhe ΔH über eine Oberfläche 116 des mindestens einen ersten Segments 112. Mit anderen Worten ist eine Oberfläche 118 des mindestens einen zweiten Segments um die Höhe ΔH über der Oberfläche 116 des mindestens einen ersten Segments 112 angeordnet.

Die Kanten 110 des mindestens einen zweiten Segments 114 weisen jeweils insbesondere eine Kantenwand 120 auf (Fig. 3). Die entsprechende Kantenwand 120 ist beispielsweise parallel zur Höhenrichtung z der Probe 100 und senkrecht zur Haupterstreckungsebene E (Fig. 2) der Probe 100 (d. h in einem 90°-Winkel zur Haupterstreckungsebene E) angeordnet. In Fig. 3 liegt eine Kantenwand 120 als Beispiel in der yz-Ebene. In anderen Beispielen kann die Kantenwand 120 jedoch auch geneigt zur Haupterstreckungsebene E der Probe 100 angeordnet sein (d. h in einem Winkel zur Haupterstreckungsebene E, der kleiner oder größer als 90° ist) oder auch in der xz-Ebene oder einer anderen zur Haupterstreckungsebene E senkrecht angeordneten Ebene liegen.

Die Probe 100 weist beispielsweise ein Substrat 122 auf (Fig. 3), auf dem das eine oder die mehreren erhöhten Elemente 106, welche das mindestens eine zweite Segment 114 bilden, angeordnet sind. Eine freiliegende Oberfläche des Substrats 122 bildet zum Beispiel die Oberfläche 116 des mindestens einen ersten Segments 112.

Obwohl in den Figuren nicht gezeigt, können auf dem Substrat 122 der Probe 100 auch eine oder mehrere Schichten (Beschichtungen) angeordnet sein. Wenn die Probe 100 beispielsweise eine EUV-Lithographiemaske ist, dann kann auf dem Substrat 122 z. B. eine Schutzschicht, wie zum Beispiel eine Ru-Capping-Layer, angeordnet sein. Im Fall, dass auf dem Substrat 122 eine oder mehrere Schichten angeordnet sind, können freiliegende Bereiche einer obersten dieser einen oder mehreren Schichten die Oberfläche 116 des mindestens einen ersten Segments 112 bilden.

Die niedrigeren Gebiete 108, z. B. das Substrat 122, und das eine oder die mehreren erhöhten Elemente 106 der Probe 100 können ein voneinander verschiedenes Material oder auch das gleiche Material aufweisen. Mit anderen Worten können das mindestens eine erste Segment 114 und das mindestens eine zweite Segment 114 voneinander verschiedene Materialien oder auch das gleiche Material aufweisen. Beispielsweise können die freiliegende Oberfläche 116 des mindestens einen ersten Segments 114 und die freiliegende Oberfläche 118 des mindestens einen zweiten Segments 114 voneinander verschiedene Materialien oder auch das gleiche Material aufweisen.

Weiterhin kann das mindestens eine erste Segment 112 der Probe 100 ein lichtdurchlässiges oder lichtreflektierendes Material aufweisen, und kann das mindestens eine zweite Segment 114 der Probe 100 ein lichtabsorbierendes Material aufweisen.

Um die Probe 100 zu analysieren und basierend auf der Analyse zu bearbeiten und/oder zu verwenden, kann es erforderlich sein, Konturen der Mikrostrukturen 104, d. h. zum Beispiel die Kanten 110 der zweiten erhöhten Segmente 114, zu erkennen. Beispielsweise kann es erforderlich sein, eine Position und/oder (z. B. zweidimensionale) geometrische Form der Kanten 110 der zweiten Segmente 114, zu ermitteln. Dies wird mit dem nachstehend beschriebenen Verfahren basierend auf einer Bildanalyse durchgeführt.

Die bei dem Verfahren analysierte mikrostrukturierte Probe 100 ist zum Beispiel eine Lithographiemaske (Retikel), insbesondere eine EUV- oder eine DUV-Lithographiemaske. Die bei dem Verfahren analysierte mikrostrukturierte Probe 100 kann jedoch zum Beispiel auch ein mittels Mikrolithographie strukturierter Wafer sein oder eine andere Art von mikrostrukturierter Probe.

Die bei dem Verfahren analysierte mikrostrukturierte Probe 100 ist zum Beispiel für eine Arbeitswellenlänge im DUV und/oder EUV-Bereich eingerichtet. Die mikrostrukturierte Probe 100 ist zum Beispiel für eine Arbeitswellenlänge von weniger als 250 nm, weniger als 200 nm und/oder weniger als 15 nm ausgelegt. Die bei dem Verfahren analysierte mikrostrukturierte Probe 100 kann jedoch auch für eine Arbeitswellenlänge in anderen Bereichen des elektromagnetischen Spektrums oder auch gar nicht für eine Belichtung mit Arbeitslicht eingerichtet sein.

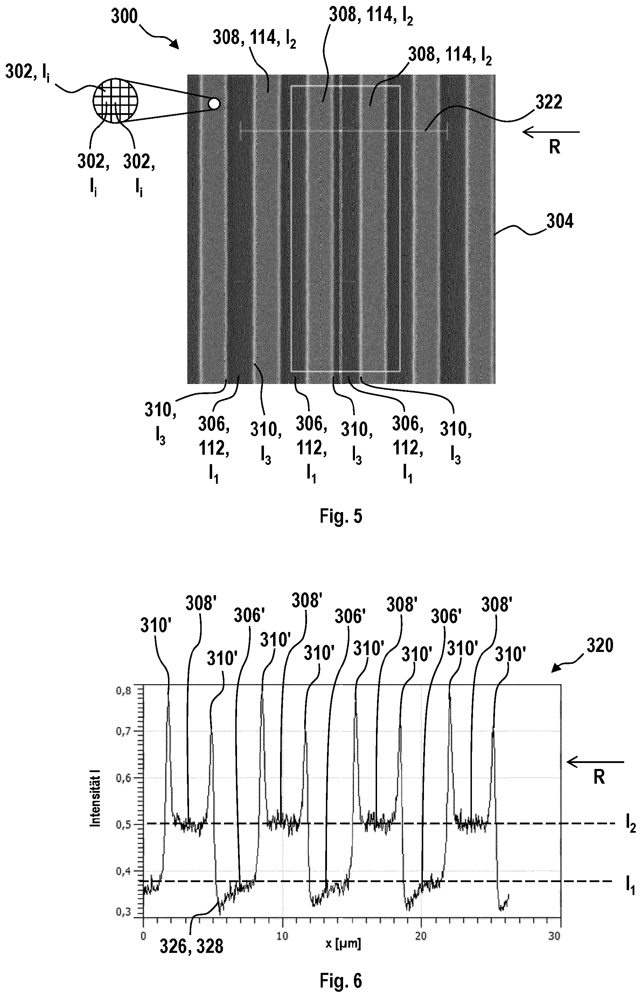

In einem ersten Schritt S1 des Verfahrens wird ein mikroskopisch erfasstes Bild 300 (Fig. 5) der Probe 100 (z. B. eines Teils der Probe 100) bereitgestellt.

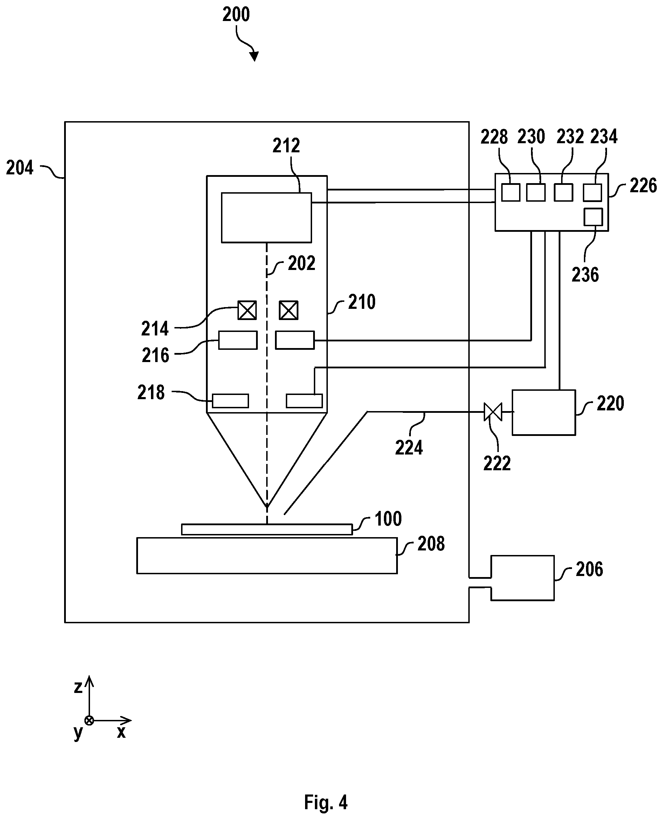

Das mikroskopisch erfasste Bild 300 wird beispielsweise mit einer Bildaufnahmeeinrichtung 200 (Fig. 4) aufgenommen, die mithilfe eines Teilchenstrahls, wie zum Beispiel eines Elektronenstrahls 202 oder eines Ionenstrahls ein Bild 300 erzeugt.

Lediglich beispielhaft ist in Fig. 4 ein Rasterelektronenmikroskop 200 als ein Beispiel einer Bildaufnahmeeinrichtung 200 gezeigt. In Fig. 4 sind schematisch im Schnitt einige Komponenten der Vorrichtung 200 dargestellt, die zum Abbilden der Probe 100 eingesetzt werden können.

Darüber hinaus kann die Vorrichtung 200 optional auch zum Elektronenstrahlinduzierten Bearbeiten und/oder Reparieren (z. B. Ätzen, Deponieren) der Probe 100 eingesetzt werden. Beispielsweise handelt es sich bei der Vorrichtung 200 um eine Reparaturvorrichtung (Reparaturtool) für Photomasken für die Mikrolithographie, zum Beispiel für Photomasken für eine DUV- oder EUV-Lithographieanlage.

Die in Fig. 4 gezeigte Vorrichtung 200 repräsentiert z. B. ein modifiziertes Rasterelektronenmikroskop 200. Hierbei wird ein Elektronenstrahl 202 zum Abbilden der Probe 100 eingesetzt. Die Vorrichtung 200 ist Großteils in einem Vakuum-Gehäuse 204 angeordnet. Ein von dem Vakuum-Gehäuse 204 umschlossener Raum wird von einer Vakuum-Pumpe 206 auf einem bestimmten Gasdruck gehalten.

Die zu bearbeitende Probe 100 wird auf einem Probentisch 208 angeordnet. Der Probentisch 208 ist beispielsweise dazu eingerichtet, die Position der Probe 100 in drei zueinander senkrechten Raumrichtungen x, y, z und beispielsweise zusätzlich in drei zueinander senkrechten Drehachsen auf wenige Nanometer genau einzustellen.

Die Vorrichtung 200 weist eine Elektronensäule 210 auf. Die Elektronensäule 210 umfasst eine Elektronenquelle 212 zum Bereitstellen des Elektronenstrahls 202. Die Elektronensäule 210 umfasst weiterhin eine Elektronen- oder Strahloptik 214. Die Elektronenquelle 212 erzeugt den Elektronenstrahl 202 und die Elektronen- oder Strahloptik 214 bündelt den Elektronenstrahl 202 und richtet ihn am Ausgang der Säule 210 auf die Probe 100. Die Elektronensäule 210 umfasst außerdem eine Ablenkeinheit 216 (Scan-Einheit 216), welche dafür eingerichtet ist, den Elektronenstrahl 202 über die Oberfläche der Probe 100 zu führen (zu scannen). Anstatt der in der Säule 210 angeordneten Ablenkeinheit 216 (Scan-Einheit 216) kann auch eine - nicht gezeigte - außerhalb der Säule 210 angeordnete Ablenkeinheit (Scan-Einheit) verwendet werden.

Die Vorrichtung 200 umfasst weiterhin einen Detektor 218 zum Nachweisen der von dem einfallenden Elektronenstrahl 202 im Material der Probe 100 erzeugten Sekundärelektronen und/oder rückgestreuten Elektronen. Der Detektor 218 ist beispielsweise, wie gezeigt, in der Elektronensäule 210 ringförmig um den Elektronenstrahl 202 angeordnet. Alternativ und/oder zusätzlich zu dem Detektor 218 kann die Vorrichtung 200 auch andere/weitere Detektoren zum Nachweisen von Sekundärelektronen und/oder rückgestreuten Elektronen aufweisen (in Fig. 4 nicht gezeigt).

Die Vorrichtung 200 kann optional auch eine Gas-Bereitstellungseinheit 220 zum Zuführen von Prozessgas zur Oberfläche der Probe 100 umfassen. Die Gas-Bereitstellungseinheit 220 weist beispielsweise ein Ventil 222 und eine Gasleitung 224 auf. Der von der Elektronensäule 210 an einen Ort auf der Oberfläche der Probe 100 gerichtete Elektronenstrahl 202 kann in Zusammenwirkung mit dem von der Gas-Bereitstellungseinheit 220 von außen über das Ventil 222 und die Gasleitung 224 zugeführten Prozessgas einen Elektronstrahl-induzierten Bearbeitungsprozess (EBIP: "electron-beam induced processing") durchführen. Dies umfasst insbesondere ein Abscheiden (Deponieren) und/oder ein Ätzen von Material.

Die Vorrichtung 200 weist außerdem eine Rechenvorrichtung 226, wie beispielsweise einen Computer, mit einer Steuereinrichtung 228, einer Erzeugungseinrichtung 230, einer ersten Ermittlungseinrichtung 232, einer zweiten Ermittlungseinrichtung 234 und einer dritten Ermittlungseinrichtung 236 auf. Die Rechenvorrichtung 226 ist in dem Beispiel von Fig. 4 außerhalb des Vakuum-Gehäuses 204 angeordnet.

Die Steuereinrichtung 228 dient z. B. zum Steuern der Vorrichtung 200. Beispielsweise steuert die Steuereinrichtung 228 durch Ansteuern der Elektronensäule 210 die Bereitstellung des Elektronenstrahls 202. Dabei steuert die Steuereinrichtung 228 unter anderem durch Ansteuern der Scan-Einheit 216 das Führen des Elektronenstrahls 202 über die Oberfläche der Probe 100. Die Steuereinrichtung 228 kann auch die Gas-Bereitstellungseinheit 220 zum Bereitstellen von Prozessgas ansteuern.

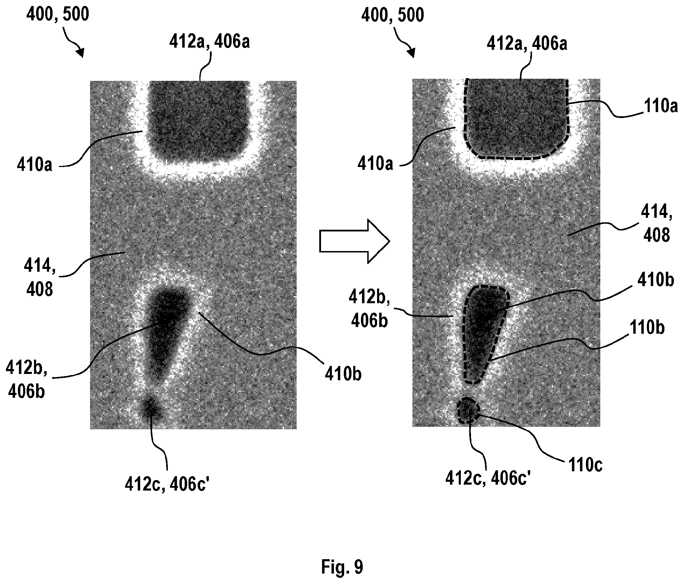

Die Erzeugungseinrichtung 230 empfängt Messdaten des Detektors 218 und/oder anderer Detektoren der Vorrichtung 200 und erzeugt aus den Messdaten Bilder 300, 500 (Fig. 5, 9), die auf einem Monitor (nicht gezeigt) dargestellt werden können. Eine räumliche Auflösung der erzeugten Bilder 300, 500 liegt beispielsweise im Bereich weniger Nanometer.

In Fig. 5 ist ein Beispiel eines mikroskopisch erfassten Bildes 300 von einer Probe, ähnlich der Probe 100 in Fig. 2, gezeigt. Das Bild 300 ist zum Beispiel mit dem Rasterelektronenmikroskop 200 aus Fig. 4 erfasst. Bei dem Bild 300 handelt es sich also zum Beispiel um ein Rasterelektronenmikroskop-Bild (REM-Bild).

Das Bild 300 ist zum Beispiel entlang einer Sehlinie S (Fig. 3) aufgenommen, welche parallel zur Höhenrichtung z der Probe 100 angeordnet ist.

Das Bild 300 weist eine Vielzahl von Pixeln 302 (eine Anzahl n Pixel) auf, von denen beispielhaft drei in einem vergrößerten Teilausschnitt in Fig. 5 mit einem Bezugszeichen versehen sind. Zum Beispiel weist das Bild 300 eine Anzahl n Pixel 302 auf, wobei n eine natürliche Zahl größer eins ist. Die Pixel 302 sind insbesondere in einer zweidimensionalen Anordnung angeordnet. Das Bild 300 weist außerdem jedem i-ten Pixel 302 zugeordnet einen Intensitätswert Iᵢ, ("Grauwert") mit i = 1 bis n auf. Die Intensitätswerte Iᵢ der n Pixel 302 bilden eine zweidimensionale Intensitätsverteilung 304 des Bildes 300.

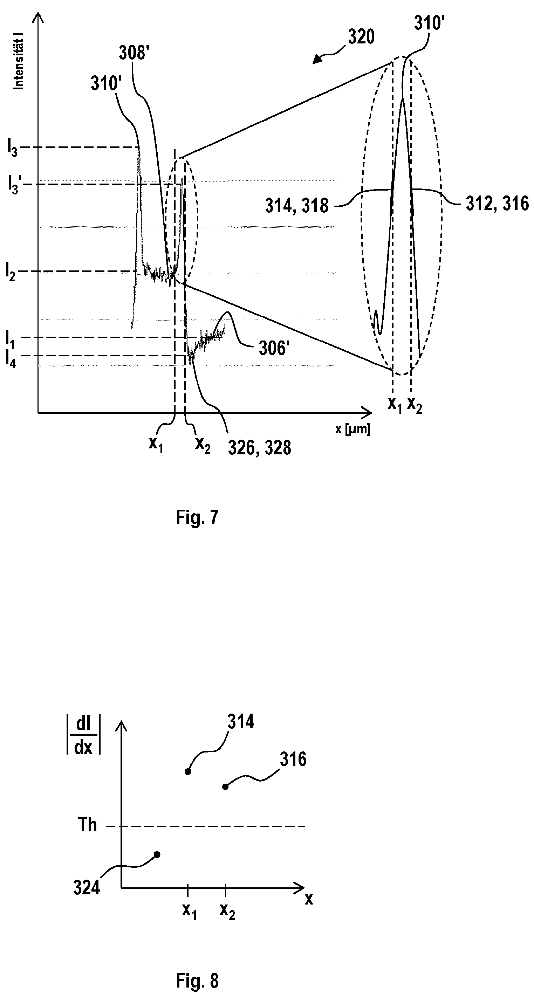

Das Bild 300 in Fig. 5 zeigt beispielhaft hellere und dunklere Bereiche 306, 308 mit unterschiedlichen Intensitäten I₁, I₂. Insbesondere wird das mindestens eine erste Segment 112 der Probe 100 (Fig. 2) beispielsweise mit kleinerer Intensität I₁ (d. h. dunkler) in einem ersten Bereich 306 bzw. in ersten Bereichen 306 in dem Bild 300 abgebildet. Weiterhin wird beispielsweise das mindestens eine zweite Segment 114 der Probe 100 (Fig. 2) mit größerer Intensität I₂ (d. h. heller) in einem zweiten Bereich 308 bzw. in zweiten Bereichen 308 in dem Bild 300 abgebildet. In dem Beispiel von Fig. 5 ist I₂ also größer als I₁ (siehe auch Fig. 6 und 7).

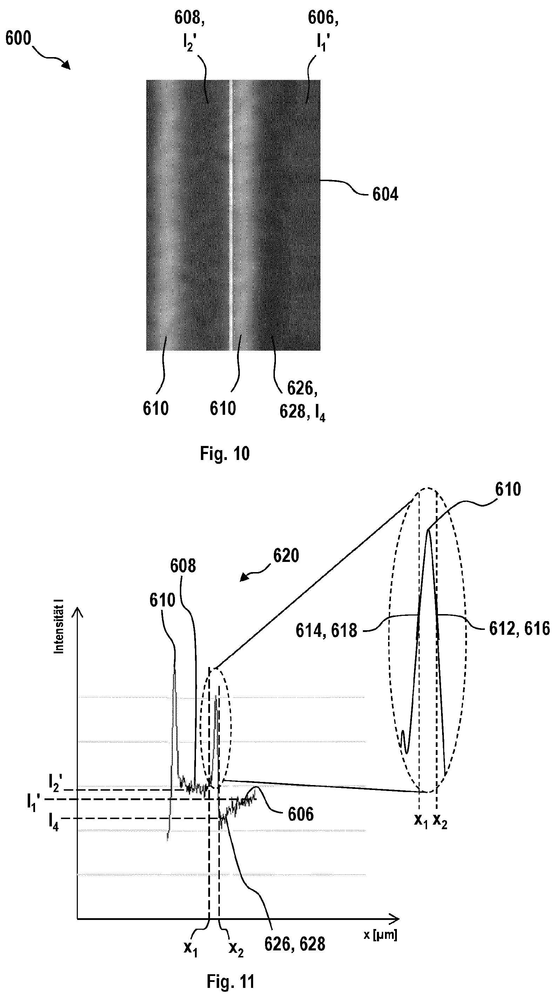

In anderen Beispielen (Fig. 10 und 11) können das mindestens eine erste Segment 112 und das mindestens eine zweite Segment 114 der Probe 100 (Fig. 2) jedoch beispielsweise auch - abgesehen von einer Abschattung und/oder Randaufhellung - mit der (z. B. ungefähr) gleichen mittleren Intensität I₁', I₂' abgebildet werden (d. h. I₁' = I₂' oder I₁' ≈ I₂').

Bei Abbildung der Kanten 110 (Fig. 2) des mindestens einen zweiten erhöhten Segments 114 in dem Bild 300 (Fig. 5) kann eine sog. Randaufhellung 310 auftreten, wie in Fig. 5 zu sehen. Im Bereich dieser Randaufhellung 310 ist eine Intensität I₃, I₃' des Bildes 300 jeweils größer als in dem ersten und zweiten Bereich 306, 308 (siehe auch Fig. 7).

In einem optionalen zweiten Schritt S2 des Verfahrens wird eine Bildvorverarbeitung zur Minderung eines Rauschanteils der zweidimensionalen Intensitätsverteilung 304 (Fig. 5) vorgenommen.

In einem dritten Schritt S3 des Verfahrens werden basierend auf dem Bild 300 mehrere Kandidaten 312, 314 (Fig. 7) für ein Abbild einer Kante 110 (Fig. 2) des zweiten Segments 114 ermittelt. Dies erfolgt anhand einer Berechnung von Gradienten 316, 318 (d. h. ersten Ableitungen 316, 318) der zweidimensionalen Intensitätsverteilung 304 (Fig. 5) des Bildes 300.

Jeder Kantenkandidat 312, 314 entspricht einem möglichen Abbild ein und derselben realen Kante 110 des zweiten Segments 114 der Probe 100. Mit anderen Worten wird bei dem Berechnen der Gradienten 316, 318 des Bildes 300 der Probe 100 für ein und dieselbe Kante 110 des zweiten Segments 114 der Probe 100 mehr als ein Kandidat für ein Abbild der Kante 110 gefunden.

Die mehreren Kantenkandidaten 312, 314 werden zum Beispiel von der ersten Ermittlungseinrichtung 232 der Vorrichtung 200 (Fig. 4) ermittelt.

Es wird angemerkt, dass in den Figuren, insbesondere Fig. 7, aus Gründen der Veranschaulichung lediglich Gradienten 316, 318 einer eindimensionalen Intensitätsverteilung 320 (Fig. 6) gezeigt sind. Dennoch wird die Gradientenbildung in Schritt S3 bevorzugt als Ermittlung von Gradienten in der zweidimensionalen Intensitätsverteilung 304 (Fig. 5) des Bildes 300 ausgeführt.

Zum Beispiel werden die Kantenkandidaten 312, 314 (Fig. 7) durch Anwendung eines sog. Sobel-Operators und/oder auch einer anderen geeigneten Methode in der zweidimensionalen Intensitätsverteilung 304 (Fig. 5) des Bildes 300 ermittelt. Beispielsweise wird für jedes Pixel 302 des Bildes 300 ein Gradient 316, 318 der Intensitätsverteilung 304 basierend auf Intensitätswerten Iᵢ des entsprechenden Pixels 302 und der dieses Pixel 302 umgebenden Pixel 302 ermittelt. Somit wird aus dem Bild 300 zum Beispiel eine Matrix von Gradienten 316, 318 abgeleitet. An denjenigen Pixeln 302, an denen sich die Intensität I (d. h. Helligkeit) des Originalbildes 300 am stärksten ändert (entsprechend einem großen Gradienten) werden dann Kandidaten 312, 314 für Kanten 110 (Fig. 2) des in dem Bild 300 erfassten mindestens einen zweiten Segments 114 ermittelt.

In einem vierten Schritt S4 des Verfahrens wird eine eindimensionale Intensitätsverteilung 320 (Fig. 7) des Bildes 300 in einer Richtung R (Fig. 5) senkrecht zu den mehreren Kantenkandidaten 312 ermittelt.

Die eindimensionale Intensitätsverteilung 320 wird zum Beispiel von der zweiten Ermittlungseinrichtung 234 der Vorrichtung 200 (Fig. 4) ermittelt.

Fig. 6 zeigt ein Beispiel einer eindimensionalen Intensitätsverteilung 320 des Bildes 300 in der Richtung R senkrecht zu den mehreren Kantenkandidaten 312, 314. Insbesondere zeigt Fig. 6 die Intensitätsverteilung 320 des Bildes 300 entlang der Linie 322 in Fig. 5. In Fig. 6 ist insbesondere ein Graph der eindimensionalen Intensitätsverteilung 320 des Bildes 300 als Funktion eines Ortes x entlang der Richtung R gezeigt. In dem gezeigten Beispiel ist die orthogonale Richtung R parallel zur x-Richtung des Bildes (Fig. 5), und ist somit die Intensitätsverteilung 320 in Fig. 6 als Funktion einer x-Koordinate des Bildes 300 gezeigt.

Die eindimensionale Intensitätsverteilung 320 in dem Beispiel von Fig. 6 weist erste Bereiche 306' mit einem ersten mittleren Intensitätswert I₁ auf, welche den dunkleren Bereichen 306 in Fig. 5 und damit einer Abbildung der ersten Segmente 112 der Probe 100 entsprechen. Die eindimensionale Intensitätsverteilung 320 weist außerdem zweite Bereiche 308' mit einem zweiten mittleren Intensitätswert I₂ auf, welche den helleren Bereichen 308 in Fig. 5 und damit einer Abbildung der zweiten Segmente 114 der Probe 100 entsprechen. Der zweite mittlere Intensitätswert I₂ ist insbesondere größer als der erste mittlere Intensitätswert I₁. Des Weiteren erscheinen die Randaufhellungen 310 an den Kanten 110 der zweiten Segmente 114 als Maxima 310' der Intensitätsverteilung 320 in Fig. 6.

Fig. 7 zeigt einen vergrößerten Teilbereich der eindimensionalen Intensitätsverteilung 320 aus Fig. 6.

Die Randaufhellungen 310 (Fig. 5) im Bereich der Abbildung der Kanten 110 (Fig. 2) erscheinen in der eindimensionalen Intensitätsverteilung 320 (Fig. 6 und 7) als Maxima 310'. Aufgrund der Randaufhellung 310 werden im Bereich der Abbildung einer jeweiligen Kante 110 zwei Gradienten 316, 318 mit großem Betrag an den Flanken des jeweiligen Maxima 310', d. h. an zwei verschiedenen Positionen x₁, x₂, ermittelt. Somit werden zwei Kandidaten 312, 314 für ein Abbild einer jeweiligen Kante 110 ermittelt. Mit anderen Worten werden entlang der Richtung R (Fig. 5) zwei unterschiedliche mögliche Positionen x₁, x₂ (Fig. 7) für eine jeweilige Kante 110 ermittelt. In einem Beispiel, in dem die orthogonale Richtung R parallel zur x-Richtung des Bildes 300 ist, werden zum Beispiel zwei mögliche x-Positionen x₁, x₂ für die Kante 110 ermittelt.

Bei dem Ermitteln der mehreren (z. B. parallelen) Kantenkandidaten 312, 314 (Fig. 7) für ein Abbild einer Kante 110 des zweiten Segments 114 basierend auf den Gradienten 316, 318 der zweidimensionalen Intensitätsverteilung 304 in Schritt S4 kann optional ein vorbestimmter Schwellenwert Th angewendet werden. Dies ist in Fig. 8 für den eindimensionalen Fall veranschaulicht. Fig. 8 zeigt insbesondere in einem Diagramm einen Betrag eines Gradienten (Betrag der ersten Ableitung dI/dx) der Intensitätsverteilung I aus Fig. 7 als Funktion des Ortes x. Beispielsweise kann bei dem Verfahren vorgesehen sein, in Schritt S4 nur Gradienten 316, 318 der zweidimensionalen Intensitätsverteilung 304, deren Betrag größer als der vorbestimmte Schwellenwert Th ist, als Kantenkandidaten 312, 314 zu ermitteln. Wohingegen Gradienten 324 (Fig. 8) der zweidimensionalen Intensitätsverteilung 304, deren Betrag kleiner als der vorbestimmte Schwellenwert Th ist, zum Beispiel nicht als Kantenkandidaten 312, 314 klassifiziert werden.

Bei einer Abbildung der Probe 100 kann auch eine Schattenbildung 326 (Fig. 6) auftreten, die in dem Bild 300 der Probe 100 sichtbar wird. Insbesondere kann es zu einer Schattenbildung 326 des zweiten Segments 114 (Fig. 2 und 3) in einem an das zweite Segment 114 angrenzenden Bereich des ersten Segments 112 kommen. Der Schatten 326 führt zu einem Schattenbereich 328 in dem Bild 300 und der eindimensionalen Intensitätsverteilung 320. Es wird angemerkt, dass in den Figuren der Schattenbereich 328 nur in Fig. 6 und 7 zu sehen ist. Mit anderen Worten führt der Schatten 326 dazu, dass das mindestens eine erste Segment 112 der Probe 100 (Fig. 2) in dem Schattenbereich 328 mit einer kleineren mittleren Intensität I₄ (Fig. 7) als außerhalb des Schattenbereichs 328 (d. h. im Bereich 306' in Fig. 7) abgebildet wird.

Der Intensitätsunterschied zwischen dem zweiten Bereich 308' und dem ersten Bereich 306' (I₂ - I₁) und/oder der Intensitätsunterschied zwischen dem zweiten Bereich 308' und dem Schattenbereich 328 (I₂ - I₄) können im nächsten Schritt des Verfahrens zur Auswahl eines der ermittelten Kandidaten 312, 314 als Abbild der Kante 110 des zweiten Segments 114 herangezogen werden.

In einem fünften Schritt S5 des Verfahrens wird derjenige der mehreren Kantenkandidaten 312, 314 (Fig. 7) als das Abbild der Kante 110 (Fig. 2) des zweiten Segments 114 ermittelt, welcher unter den mehreren Kantenkandidaten 312, 314 örtlich am nächsten bei dem ersten Bereich 306' und/oder dem Schattenbereich 328 der eindimensionalen Intensitätsverteilung 320 liegt.

Das Ermitteln des besten Kantenkandidaten 312, 314 für ein Abbild der Kante 110 in Schritt S5 wird zum Beispiel von der dritten Ermittlungseinrichtung 236 der Vorrichtung 200 (Fig. 4) ausgeführt.

In dem Beispiel von Fig. 7 liegt von den beiden in Schritt S4 ermittelten Kantenkandidaten 312, 314 der Kantenkandidat 312 am nächsten bei dem ersten Bereich 306' der eindimensionalen Intensitätsverteilung 320 und wird somit als Abbild der Kante 110 des zweiten Segments 114 ermittelt. Beispielsweise wird eine Position x₂ des Kantenkandidaten 312 als Position der Kante 110 des zweiten Segments 114 ermittelt.

Zusätzlich oder alternativ kann in Schritt S5 auch betrachtet werden, dass von den beiden in Schritt S4 ermittelten Kantenkandidaten 312, 314 der Kantenkandidat 312 am nächsten bei dem Schattenbereich 328 der eindimensionalen Intensitätsverteilung 320 liegt. In dem Beispiel von Fig. 7 wird dabei derselbe Kantenkandidat 312 als Abbild der Kante 110 des zweiten Segments 114 ermittelt.

Durch das vorgeschlagene Verfahren kann die Lage bzw. Position von Kanten 110 der mikrostrukturierten Probe 100 (Fig. 2) besser erkannt werden. Insbesondere sind die mit dem vorgeschlagenen Verfahren ermittelten Positionen der Kanten 110 detailgenauer und positionsgenauer an die geometrische Form des mindestens einen zweiten Segments 114 angelegt. Des Weiteren kann im Vergleich zu herkömmlichen Methoden eine Kantenposition ermittelt werden, die näher in Richtung der tiefergelegenen Struktur 108, 112 (Fig. 2) liegt.

Fig. 9 veranschaulicht ein weiteres Beispiel des Verfahrens zum Analysieren einer Probe 400 ähnlich der Probe 100 in Fig. 2. In Fig. 9 ist ein Bild 500 (z. B. REM-Bild 500) der Probe 400 vor (linke Abbildung) und nach (rechte Abbildung) einer Kantenerkennung zu sehen. Die Probe 400 weist mindestens drei erste Segmente 412a, 412b, 412c (ähnlich dem ersten Segment 112 in Fig. 2) und mindestens ein zweites Segmente 414 (ähnlich dem zweiten Segment 114 in Fig. 2) auf. Die ersten Segmente 412a, 412b, 412c der Probe 400 werden in dem Bild 500 als erste Bereiche 406a, 406b, 406c abgebildet. Hierbei zeigen die ersten Bereiche 406a, 406b jeweils eine Randaufhellung 410a, 410b ähnlich der Randaufhellung 310 in Fig. 5. Der erste Bereiche 406c zeigt jedoch nur eine sehr schwache bzw. keine Randaufhellung. Weiterhin wird das zweite Segment 414 der Probe 400 in dem Bild 500 als zweiter Bereich 408 abgebildet.

Durch das vorstehend beschriebene Verfahren können Kanten 110a, 110b, 110c der den ersten Segmenten 412a, 412b, 412c entsprechenden ersten Bereichen 406a, 406b, 406c positionsgenau erkannt werden, wie rechts in Fig. 9 veranschaulicht. Insbesondere liegen die so ermittelten Kanten 110a, 110b, 110c näher an den tiefergelegenen Strukturen 412a, 412b, 412c der Probe 400.

In einem Fall, in dem bei der Abbildung der Probe 100 eine Schattenbildung 326, 626 auftritt (Fig. 7, 10 und 11), kann in Schritt S5 - anstatt des ersten Bereichs 306' der eindimensionalen Intensitätsverteilung 320 - auch der Schattenbereich 328, 628 der eindimensionalen Intensitätsverteilung 320, 620 zur Auswahl aus den Kantenkandidaten 312, 314 (Fig. 7) bzw. 612, 614 (Fig. 11) herangezogen werden. Mit anderen Worten kann in Schritt S5 von den beiden ermittelten Kantenkandidaten 312, 314 (Fig. 7) bzw. 612, 614 (Fig. 11) der Kantenkandidat 312 bzw. 612, der am nächsten bei dem Schattenbereich 328, 628 der eindimensionalen Intensitätsverteilung 320, 620 liegt, als Abbild der Kante 110 des zweiten Segments 114 (Fig. 2) ermittelt werden.

Die Berücksichtigung einer Schattenbildung 326 erweist sich besonders in einem Fall von Vorteil, in dem das mindestens eine erste und zweite Segment 112, 114 das gleiche Material aufweisen und - abgesehen von einer Abschattung - mit der gleichen mittleren Helligkeit I₁', I₂' in dem Bild 300, 600 abgebildet werden.

Fig. 10 zeigt ein weiteres mit der Vorrichtung aus Fig. 4 aufgenommenes Bild 600 einer mikrostrukturierten Probe 100 gemäß einer Ausführungsform, wobei das Verwenden einer Abschattung zur Kantenerkennung veranschaulicht ist. Fig. 11 zeigt eine eindimensionale Intensitätsverteilung 620 des in Fig. 10 gezeigten Bildes 600. Hier werden das mindestens eine erste Segment 112 und das mindestens eine zweite Segment 114 der Probe 100 (Fig. 2) - abgesehen von einer Abschattung 626, 628 und einer Randaufhellung 610 - mit etwa der gleichen mittleren Intensität I₁', I₂' (Fig. 11) in dem Bild 600 abgebildet (d. h. I₁' ≈ I₂').

In Fig. 11 sind insbesondere die in Schritt S4 basierend auf der zweidimensionalen Intensitätsverteilung 604 (Fig. 10) ermittelten Gradienten 616, 618 und Kantenkandidaten 612, 614 in einer eindimensionalen Intensitätsverteilung 620 gekennzeichnet. Ein erster Bereich 606 mit einer ersten mittleren Intensität I₁' der eindimensionalen Intensitätsverteilung 620 entspricht einer Abbildung des mindestens einen ersten Segments 112 der Probe 100. Ein zweiter Bereich 608 mit einer zweiten mittleren Intensität I₂' der eindimensionalen Intensitätsverteilung 620 entspricht einer Abbildung des mindestens einen zweiten Segments 114. Außerdem entspricht ein Schattenbereich 628 mit einer weiteren mittleren Intensität I₄ einer Abbildung des abgeschatteten Bereichs 628 des mindestens einen ersten Segments 112.

Insbesondere ist der mittlere Intensitätswert I₂' des zweiten Bereichs 608 der eindimensionalen Intensitätsverteilung 620 aufgrund der Schattenbildung 626 größer als der mittlere Intensitätswert I₄ des Schattenbereichs 628 der eindimensionalen Intensitätsverteilung 620.

In dem Beispiel von Fig. 10 und 11 wird in Schritt S5 des Verfahrens derjenige der in Schritt S4 ermittelten Kantenkandidaten 612, 614 als Abbild der Kante 110 (Fig. 2) ermittelt, der am nächsten bei dem Schattenbereich 628 der eindimensionalen Intensitätsverteilung 620 liegt. Dies ist im Beispiel von Fig. 11 der Kantenkandidaten 612 bei der Position x₂.

Obwohl die vorliegende Erfindung anhand von Ausführungsbeispielen beschrieben wurde, ist sie vielfältig modifizierbar.

### BEZUGSZEICHENLISTE

- 100: Probe
- 104: Mikrostruktur
- 106: Element
- 108: Gebiet
- 110: Kante
- 110a: Kante
- 110b: Kante
- 110c: Kante
- 112: Segment
- 114: Segment
- 116: Oberfläche
- 118: Oberfläche
- 120: Wand
- 122: Substrat
- 200: Bildaufnahmeeinrichtung
- 202: Elektronenstrahl
- 204: Gehäuse
- 206: Pumpe
- 208: Probentisch
- 210: Elektronensäule
- 212: Elektronenquelle
- 214: Elektronen- oder Strahloptik
- 216: Ablenkeinheit
- 218: Detektor
- 220: Gas-Bereitstellungseinheit
- 222: Ventil
- 224: Gasleitung
- 226: Rechenvorrichtung
- 228: Steuereinrichtung
- 230: Erzeugungseinrichtung
- 232: Ermittlungseinrichtung
- 234: Ermittlungseinrichtung
- 236: Ermittlungseinrichtung
- 300, 300": Bild
- 302: Pixel
- 304: Intensitätsverteilung
- 306, 306': Bereich
- 308, 308', 308": Bereich
- 310, 310', 310": Randaufhellung
- 312: Kandidat
- 314: Kandidat
- 316: Gradient
- 318: Gradient
- 320: Intensitätsverteilung
- 322: Linie
- 324: Gradient
- 326: Schatten
- 328: Bereich
- 400: Probe
- 406a: Bereich
- 406b: Bereich
- 406c: Bereich
- 410a: Randaufhellung
- 410b: Randaufhellung
- 412a: Segment
- 412b: Segment
- 412c: Segment
- 414: Segment
- 408: Bereich
- 410a, 410b: Randaufhellung
- 500: Bild
- 600: Bild
- 604: Intensitätsverteilung
- 606: Bereich
- 608: Bereich
- 610: Randaufhellung
- 612: Kandidat
- 614: Segment
- 616: Gradient
- 618: Gradient
- 620: Intensitätsverteilung
- 626: Schatten
- 628: Bereich
- dI/dx: Gradient (erste Ableitung)
- E: Ebene
- H: Höhe
- H2: Höhe
- H1: Höhe
- ΔH: Höhe
- I₁, I₂: Intensität
- I₁', I₂': Intensität
- I₃, I₃: Intensität
- Iᵢ: Intensität
- R: Richtung
- S: Sehlinie
- S2-S5: Verfahrensschritte
- Th: Schwellenwert
- x, y, z: Richtung
- x₁, x₂: Position

## Patentansprüche

1. Verfahren zum Analysieren eines Bildes (300) einer mikrostrukturierten Probe (100) für die Mikrolithographie, wobei die Probe (100) mindestens ein erstes Segment (112) und mindestens ein zweites gegenüber dem ersten Segment (112) erhöhtes Segment (114) mit einer Kante (110) aufweist, und wobei das Bild (300) mehrere Pixel (302) und eine zweidimensionale Intensitätsverteilung (304) in Abhängigkeit der Pixel (302) aufweist, die Schritte umfassend:
a) Ermitteln (S2) mehrerer Kantenkandidaten (312, 314) für ein Abbild der Kante (110) des mindestens einen zweiten Segments (114) basierend auf Gradienten (316, 318) der zweidimensionalen Intensitätsverteilung (304),
b) Ermitteln (S3) einer eindimensionalen Intensitätsverteilung (320) des Bildes (300) in einer Richtung (R) senkrecht zu einem, zu mehreren oder zu allen der mehreren Kantenkandidaten (312, 314), wobei die eindimensionale Intensitätsverteilung (320) entlang der Richtung (R) einen ersten Bereich (306') mit einem ersten mittleren Intensitätswert (I₁), die mehreren Kantenkandidaten (312, 314) und einen zweiten Bereich (308') mit einem zweiten mittleren Intensitätswert (I₂), der größer als der erste mittlere Intensitätswert (I₁) ist, aufweist, und
c) Ermitteln (S4) desjenigen der mehreren Kantenkandidaten (312, 314) als das Abbild der Kante (110) des mindestens einen zweiten Segments (114), welcher unter den mehreren Kantenkandidaten (312, 314) am nächsten bei dem ersten Bereich (306') der eindimensionalen Intensitätsverteilung (320) liegt.

2. Verfahren nach Anspruch 1, wobei der erste Bereich (306') der eindimensionalen Intensitätsverteilung (320) des Bildes (300) auf einer Abbildung des mindestens einen ersten Segments (112) der Probe (100) basiert, und der zweite Bereich (308') der eindimensionalen Intensitätsverteilung (320) des Bildes (300) auf einer Abbildung des mindestens einen zweiten Segments (114) der Probe (100) basiert.

3. Verfahren nach Anspruch 1 oder 2, wobei das mindestens eine erste Segment (112) der Probe (100) ein erstes Material aufweist und das mindestens eine zweite Segment (114) der Probe (100) ein von dem ersten Material verschiedenes zweites Material aufweist.

4. Verfahren nach Anspruch 3, wobei der zweite mittlere Intensitätswert (I₂) des zweiten Bereichs (308') der eindimensionalen Intensitätsverteilung (320) des Bildes (300) aufgrund des Materialunterschieds des mindestens einen ersten und zweiten Segments (112, 114) der Probe (100) größer als der erste mittlere Intensitätswert (I₁) des ersten Bereichs (306') der eindimensionalen Intensitätsverteilung (320) des Bildes (300) ist.

5. Verfahren nach Anspruch 1 oder 2, wobei das mindestens eine erste und zweite Segment (112, 114) der Probe (100) das gleiche Material aufweisen.

6. Verfahren nach Anspruch 5, wobei der zweite mittlere Intensitätswert (I₂) des zweiten Bereichs (308') der eindimensionalen Intensitätsverteilung (320) des Bildes (300) aufgrund einer Schattenbildung (326) benachbart zur Kante (110) des mindestens einen zweiten Segments (114) der Probe (100) größer als der erste mittlere Intensitätswert (I₁) des ersten Bereichs (306') der eindimensionalen Intensitätsverteilung (320) des Bildes (300) ist.

7. Verfahren nach einem der Ansprüche 1 - 6, wobei bei dem Ermitteln der mehreren Kantenkandidaten (312, 314) basierend auf den Gradienten (316, 318) der zweidimensionalen Intensitätsverteilung (304) ein vorbestimmter Schwellenwert (Th) angewendet wird, sodass für Gradienten (316, 318) der zweidimensionalen Intensitätsverteilung (304), deren Betrag größer als der vorbestimmte Schwellenwert (Th) ist, ein entsprechender Kantenkandidat (316, 318) ermittelt wird, und für Gradienten (324) der zweidimensionalen Intensitätsverteilung (304), deren Betrag gleich wie oder kleiner als der vorbestimmte Schwellenwert (Th) ist, kein Kantenkandidat ermittelt wird.

8. Verfahren nach einem der Ansprüche 1 - 7, wobei vor Schritt a) eine Bildvorverarbeitung (S1) zur Minderung eines Rauschanteils der zweidimensionalen Intensitätsverteilung (304) vorgenommen wird.

9. Verfahren nach einem der Ansprüche 1 - 8, wobei
die mikrostrukturierte Probe (100) für eine Arbeitswellenlänge von weniger als 250 nm, von weniger als 200 nm, von weniger als 100 nm und/oder von weniger als 15 nm ausgelegt ist, und/oder
die mikrostrukturierte Probe (100) eine Lithographiemaske, insbesondere eine EUV- oder eine DUV-Lithographiemaske, und/oder ein mittels Mikrolithographie strukturierter Wafer ist.

10. Verfahren nach einem der Ansprüche 1 - 9, wobei das mindestens eine erste Segment (112) der Probe (100) ein lichtdurchlässiges oder lichtreflektierendes Material aufweist, und das mindestens eine zweite Segment (114) der Probe (100) ein lichtabsorbierendes Material aufweist.

11. Computerprogrammprodukt, welches Befehle umfasst, die bei der Ausführung des Programms durch mindestens einen Computer diesen veranlassen, ein Verfahren nach einem der vorhergehenden Ansprüche auszuführen.

12. Vorrichtung (200) zur Analyse eines Bildes (300) einer mikrostrukturierten Probe (100) für die Mikrolithographie, wobei die Probe (100) mindestens ein erstes Segment (112) und mindestens ein zweites gegenüber dem ersten Segment (112) erhöhtes Segment (114) mit einer Kante (110) aufweist, wobei das Bild (300) mehrere Pixel (302) und eine zweidimensionale Intensitätsverteilung (304) in Abhängigkeit der Pixel (302) aufweist, und wobei die Vorrichtung (200) aufweist:
eine erste Ermittlungseinrichtung (232) zum Ermitteln mehrerer Kantenkandidaten (312, 314) für ein Abbild der Kante (110) des mindestens einen zweiten Segments (114) basierend auf Gradienten (316, 318) der zweidimensionalen Intensitätsverteilung (304),
eine zweite Ermittlungseinrichtung (234) zum Ermitteln einer eindimensionalen Intensitätsverteilung (320) des Bildes (300) in einer Richtung (R) senkrecht zu einem, zu mehreren oder zu allen der mehreren Kantenkandidaten (312, 314), wobei die eindimensionale Intensitätsverteilung (320) entlang der Richtung (R) einen ersten Bereich (306') mit einem ersten mittleren Intensitätswert (I₁), die mehreren Kantenkandidaten (312, 314) und einen zweiten Bereich (308') mit einem zweiten mittleren Intensitätswert (I₂), der größer als der erste mittlere Intensitätswert (I₁) ist, aufweist,
und
eine dritte Ermittlungseinrichtung (236) zum Ermitteln desjenigen der mehreren Kantenkandidaten (312, 314) als das Abbild der Kante (110) des mindestens einen zweiten Segments (114), welcher unter den mehreren Kantenkandidaten (312, 314) am nächsten bei dem ersten Bereich (306') der eindimensionalen Intensitätsverteilung (320) liegt.

## Claims

1. Method for analysing an image (300) of a microlithographic microstructured sample (100), wherein the sample (100) comprises at least one first segment (112) and at least one second segment (114) which has an edge (110) and is raised vis-à-vis the first segment (112), and wherein the image (300) includes a plurality of pixels (302) and a two-dimensional intensity distribution (304) depending on the pixels (302), the method comprising the following steps:
a) determining (S2) a plurality of edge candidates (312, 314) for an image representation of the edge (110) of the at least one second segment (114) on the basis of gradients (316, 318) of the two-dimensional intensity distribution (304),
b) determining (S3) a one-dimensional intensity distribution (320) of the image (300) in a direction (R) perpendicular to one of, to a plurality of or to all of the plurality of edge candidates (312, 314), wherein in the direction (R), the one-dimensional intensity distribution (320) comprises a first region (306') with a first mean intensity value (I₁), the plurality of edge candidates (312, 314) and a second region (308') with a second mean intensity value (I₂) greater than the first mean intensity value (I₁), and
c) determining (S4) the edge candidate of the plurality of edge candidates (312, 314) which among the plurality of edge candidates (312, 314) is closest to the first region (306') of the one-dimensional intensity distribution (320) as the image representation of the edge (110) of the at least one second segment (114).

2. Method according to Claim 1, wherein the first region (306') of the one-dimensional intensity distribution (320) of the image (300) is based on an image representation of the at least one first segment (112) of the sample (100), and the second region (308') of the one-dimensional intensity distribution (320) of the image (300) is based on an image representation of the at least one second segment (114) of the sample (100).

3. Method according to Claim 1 or 2, wherein the at least one first segment (112) of the sample (100) includes a first material, and the at least one second segment (114) of the sample (100) includes a second material that differs from the first material.

4. Method according to Claim 3, wherein the second mean intensity value (I₂) in the second region (308') of the one-dimensional intensity distribution (320) of the image (300) is greater than the first mean intensity value (I₁) in the first region (306') of the one-dimensional intensity distribution (320) of the image (300) on account of the difference in materials between the at least one first and second segment (112, 114) of the sample (100).

5. Method according to Claim 1 or 2, wherein the at least one first and second segment (112, 114) of the sample (100) include the same material.

6. Method according to Claim 5, wherein the second mean intensity value (I₂) in the second region (308') of the one-dimensional intensity distribution (320) of the image (300) is greater than the first mean intensity value (I₁) in the first region (306') of the one-dimensional intensity distribution (320) of the image (300) on account of a shadow (326) formed adjacent to the edge (110) of the at least one second segment (114) of the sample (100).

7. Method according to any of Claims 1-6, wherein a predetermined threshold value (Th) is applied when determining the plurality of edge candidates (312, 314) on the basis of the gradient (316, 318) of the two-dimensional intensity distribution (304), in such a way that a corresponding edge candidate (316, 318) is determined for gradients (316, 318) of the two-dimensional intensity distribution (304) whose absolute value is greater than the predetermined threshold value (Th), and no edge candidate is determined for gradients (324) of the two-dimensional intensity distribution (304) whose absolute value is less than or equal to the predetermined threshold value (Th).

8. Method according to any of Claims 1-7, wherein step a) is preceded by image preprocessing (S1) for reducing a noise component of the two-dimensional intensity distribution (304).

9. Method according to any of Claims 1-8, wherein
the microstructured sample (100) is designed for an operating wavelength of less than 250 nm, of less than 200 nm, of less than 100 nm and/or of less than 15 nm, and/or
the microstructured sample (100) is a lithography mask, in particular an EUV or a DUV lithography mask, and/or a wafer structured by microlithography.

10. Method according to any of Claims 1-9, wherein the at least one first segment (112) of the sample (100) includes a light-transmitting or light-reflecting material, and the at least one second segment (114) of the sample (100) includes a light-absorbing material.

11. Computer program product comprising instructions that, upon execution of the program by at least one computer, cause the latter to carry out a method according to any of the preceding claims.

12. Apparatus (200) for analysing an image (300) of a microlithographic microstructured sample (100), wherein the sample (100) comprises at least one first segment (112) and at least one second segment (114) which has an edge (110) and is raised vis-à-vis the first segment (112), wherein the image (300) includes a plurality of pixels (302) and a two-dimensional intensity distribution (304) depending on the pixels (302), and wherein the apparatus (200) comprises:
a first determination device (232) for determining a plurality of edge candidates (312, 314) for an image representation of the edge (110) of the at least one second segment (114) on the basis of gradients (316, 318) of the two-dimensional intensity distribution (304),
a second determination device (234) for determining a one-dimensional intensity distribution (320) of the image (300) in a direction (R) perpendicular to one of, to a plurality of or to all of the plurality of edge candidates (312, 314), wherein in the direction (R), the one-dimensional intensity distribution (320) comprises a first region (306') with a first mean intensity value (I₁), the plurality of edge candidates (312, 314) and a second region (308') with a second mean intensity value (I₂) greater than the first mean intensity value (I₁),
and
a third determination device (236) for determining the edge candidate of the plurality of edge candidates (312, 314) which among the plurality of edge candidates (312, 314) is closest to the first region (306') of the one-dimensional intensity distribution (320) as the image representation of the edge (110) of the at least one second segment (114).

## Revendications

1. Procédé d'analyse d'une image (300) d'un échantillon (100) microstructuré pour la microlithographie, l'échantillon (100) comportant au moins un premier segment (112) et au moins un deuxième segment (114), surélevé par rapport au premier segment (112), avec un bord (110), et l'image (300) comportant plusieurs pixels (302) et une distribution d'intensité bidimensionnelle (304) dépendant des pixels (302), les étapes comprenant :
a) détermination (S2) de plusieurs candidats de bord (312, 314) pour une représentation d'image du bord (110) de l'au moins un deuxième segment (114) sur la base de gradients (316, 318) de la distribution d'intensité bidimensionnelle (304),
b) détermination (S3) d'une distribution d'intensité unidimensionnelle (320) de l'image (300) dans une direction (R) perpendiculaire à un, à plusieurs candidats de bord ou à la totalité des plusieurs candidats de bord (312, 314), la distribution d'intensité unidimensionnelle (320) comportant le long de la direction (R) une première zone (306') avec une première valeur d'intensité moyenne (I₁), les plusieurs candidats de bord (312, 314) et une deuxième zone (308') avec une deuxième valeur d'intensité moyenne (I₂), qui est supérieure à la première valeur d'intensité moyenne (I₁), et
c) détermination (S4) du candidat de bord des plusieurs candidats de bord (312, 314) en tant représentation d'image du bord (110) de l'au moins un deuxième segment (114), qui précisément, parmi les plusieurs candidats de bord (312, 314), est le plus proche de la première zone (306') de la distribution d'intensité unidimensionnelle (320).

2. Procédé selon la revendication 1, la première zone (306') de la distribution d'intensité unidimensionnelle (320) de l'image (300) étant basée sur une représentation d'image de l'au moins un premier segment (112) de l'échantillon (100), et la deuxième zone (308') de la distribution d'intensité unidimensionnelle (320) de l'image (300) étant basée sur une représentation d'image de l'au moins un deuxième segment (114) de l'échantillon (100).

3. Procédé selon la revendication 1 ou 2, l'au moins un premier segment (112) de l'échantillon (100) comportant un premier matériau et l'au moins un deuxième segment (114) de l'échantillon (100) comportant un deuxième matériau différent du premier matériau.

4. Procédé selon la revendication 3, la deuxième valeur d'intensité moyenne (I₂) de la deuxième zone (308') de la distribution d'intensité unidimensionnelle (320) de l'image (300) étant supérieure à la première valeur d'intensité moyenne (I₁) de la première zone (306') de la distribution d'intensité unidimensionnelle (320) de l'image (300) en raison de la différence de matériau entre l'au moins un premier et l'au moins un deuxième segment (112, 114) de l'échantillon (100).

5. Procédé selon la revendication 1 ou 2, l'au moins un premier et l'au moins un deuxième segment (112, 114) de l'échantillon (100) comportant le même matériau.

6. Procédé selon la revendication 5, la deuxième valeur d'intensité moyenne (I₂) de la deuxième zone (308') de la distribution d'intensité unidimensionnelle (320) de l'image (300) étant supérieure à la première valeur d'intensité moyenne (I₁) de la première zone (306') de la distribution d'intensité unidimensionnelle (320) de l'image (300) en raison de la formation d'ombre (326) de manière adjacente au bord (110) de l'au moins un deuxième segment (114) de l'échantillon (100).

7. Procédé selon l'une des revendications 1 à 6, une valeur de seuil prédéfinie (Th) étant appliquée lors de la détermination des plusieurs candidats de bord (312, 314) sur la base des gradients (316, 318) de la distribution d'intensité bidimensionnelle (304) de telle sorte que, pour des gradients (316, 318) de la distribution d'intensité bidimensionnelle (304), dont la valeur absolue est supérieure à la valeur de seuil prédéfinie (Th), un candidat de bord (316, 318) correspondant est déterminé, et aucun candidat de bord n'est déterminé pour des gradients (324) de la distribution d'intensité bidimensionnelle (304), dont la valeur absolue est égale ou inférieure à la valeur de seuil prédéfinie (Th).

8. Procédé selon l'une des revendications 1 à 7, un prétraitement d'image (S1) étant réalisé avant l'étape a) pour réduire une composante de bruit de la distribution d'intensité bidimensionnelle (304).

9. Procédé selon l'une des revendications 1 à 8,
l'échantillon (100) microstructuré étant conçu pour une longueur d'onde de fonctionnement inférieure à 250 nm, inférieure à 200 nm, inférieure à 100 nm et/ou inférieure à 15 nm, et/ou
L'échantillon (100) microstructuré étant un masque lithographique, en particulier un masque lithographique EUV ou DUV, et/ou une tranche structurée par microlithographie.

10. Procédé selon l'une des revendications 1 à 9, l'au moins un premier segment (112) de l'échantillon (100) comportant un matériau transmettant la lumière ou réfléchissant la lumière, et l'au moins un deuxième segment (114) de l'échantillon (100) comportant un matériau absorbant la lumière.

11. Produit de programme d'ordinateur, qui comprend des instructions qui, lorsque le programme est exécuté par au moins un ordinateur, amènent celui-ci à exécuter un procédé selon l'une des revendications précédentes.

12. Dispositif (200) pour analyser une image (300) d'un échantillon (100) microstructuré pour la microlithographie, l'échantillon (100) comportant au moins un premier segment (112) et au moins un deuxième segment (114), surélevé par rapport au premier segment (112), avec un bord (110), l'image (300) comportant plusieurs pixels (302) et une distribution d'intensité bidimensionnelle (304) en fonction des pixels (302), et le dispositif (200) comportant :
un premier système de détermination (232) destiné à déterminer plusieurs candidats de bord (312, 314) pour une représentation d'image du bord (110) de l'au moins un deuxième segment (114) sur la base de gradients (316, 318) de la distribution d'intensité bidimensionnelle (304),
un deuxième système de détermination (234) destiné à déterminer une distribution d'intensité unidimensionnelle (320) de l'image (300) dans une direction (R) perpendiculairement à un, à plusieurs candidats de bord ou à la totalité des plusieurs candidats de bord (312, 314), la distribution d'intensité unidimensionnelle (320) comportant le long de la direction (R) une première zone (306') avec une première valeur d'intensité moyenne (I₁), les plusieurs candidats de bord (312, 314) et une deuxième zone (308') avec une deuxième valeur d'intensité moyenne (I₂), qui est supérieure à la première valeur d'intensité moyenne (I₁),
et
un troisième système de détermination (236) destiné à déterminer le candidat de bord des plusieurs candidats de bord (312, 314) en tant que la représentation d'image du bord (110) de l'au moins un deuxième segment (114), qui précisément, parmi les candidats de bord (312, 314), est le plus proche de la première zone (306') de la distribution d'intensité unidimensionnelle (320).
